# EUROPEAN PATENT APPLICATION

(11) **EP 4 753 425 A1**
(43) Date of publication of application: **03.06.2026**
(21) Application number: 24850738.6
(22) Date of filing: 09.07.2024
(51) Int. Cl.: H10K 59/131, H10K 59/121, H10K 71/00

(54) **DISPLAY SUBSTRATE AND MANUFACTURING METHOD THEREFOR, AND DISPLAY DEVICE**

(30) Priority: 10.08.2023 CN 202311018194
(71) Applicant: BOE Technology Group Co., Ltd., Beijing 100015 (CN); Hefei BOE Joint Technology Co., Ltd., Hefei, Anhui 230012 (CN); Beijing BOE Technology Development Co., Ltd., Beijing 100176 (CN)
(72) Inventor: LIU, Xiuting, Beijing 100176 (CN); YUAN, Zhidong, Beijing 100176 (CN); HAN, Ying, Beijing 100176 (CN); LI, Yongqian, Beijing 100176 (CN); ZHANG, Dacheng, Beijing 100176 (CN); ZHOU, Dandan, Beijing 100176 (CN)
(74) Representative: Durán-Corretjer, S.L.P.
(86) International application number: PCT/CN2024/104373
(87) International publication number: WO 2025/031087

(57) **Abstract**

A display substrate and a manufacturing method therefor, and a display device. The display substrate comprises a plurality of sub-pixels, each sub-pixel comprises a pixel driving circuit, and the pixel driving circuit is separately connected to data signal lines and a compensation signal line. The pixel driving circuit at least comprises a storage capacitor, the storage capacitor at least comprises two stacked capacitor plates, and the two capacitor plates are arranged between the data signal lines and the compensation signal line. For at least one capacitor electrode in at least one sub-pixel, a first distance is reserved between the edge of the side of the capacitor plate close to the compensation signal line and the edge of the side of the compensation signal line close to the capacitor plate, a second distance is reserved between the edge of the side of the capacitor plate close to the data signal line and the edge of the side of the data signal line close to the capacitor plate, and the first distance is smaller than the second distance. The present disclosure can reduce the impact of a data voltage transition on the data signal line on the storage capacitor, and prevent a data voltage transition from affecting normal operation of the pixel driving circuit.

## Description

The present application claims priority to Chinese Patent Application No. 202311018194.3 filed to the CNIPA on August 10, 2023 and entitled "Display Substrate and Manufacturing Method Therefor, and Display Device", contents of which should be construed as being incorporated into the present application by reference.

### Technical Field

The present disclosure relates to, but is not limited to, the field of display technologies, and in particular to a display substrate, a method for manufacturing the display substrate, and a display device.

### Background

An organic light emitting diode (OLED) and a quantum dot light emitting diode (QLED) are active light emitting display devices and have advantages such as self-illumination, wide viewing angle, high contrast ratio, low power consumption, very high reaction speed, lightness and thinness, flexibility, and low cost. With continuous development of display technologies, a display device in which an OLED or a QLED is used as a light emitting device and signal control is performed through a Thin Film Transistor (TFT for short) has become a mainstream product in the field of display at present.

### Summary

The following is a summary of subject matter described herein in detail. This summary is not intended to limit the protection scope of claims.

In one aspect, the present disclosure provides a display substrate, including a plurality of repetition units, wherein at least one repetition unit includes a plurality of sub-pixels forming at least two pixel rows and at least two pixel columns. At least one sub-pixel includes a pixel drive circuit, the pixel drive circuit is respectively connected to a data signal line and a compensation signal line extending along a pixel column direction. The data signal line is configured to provide a data signal to the pixel drive circuit, and the compensation signal line is configured to provide a compensation signal to the pixel drive circuit. The pixel drive circuit at least includes a storage capacitor, the storage capacitor at least includes two capacitor plates that are stacked, and the two capacitor plates are disposed between the data signal line and the compensation signal line. A first distance is provided between an edge of at least one capacitor plate in the at least one sub-pixel close to the compensation signal line and an edge of the compensation signal line close to the capacitor plate, a second distance is provided between an edge of the at least one capacitor plate close to the data signal line and an edge of the data signal line close to the capacitor plate, the first distance is less than the second distance, and the first distance and the second distance are dimensions in a pixel row direction.

In an exemplary implementation mode, a ratio of the first distance to the second distance is 0.35 to 0.75.

In an exemplary implementation mode, a ratio of the first distance to the second distance is 0.6 to 0.7.

In an exemplary implementation mode, the first distance ranges from 5.5 µm to 6.5 µm and the second distance is 8.5 µm to 9.5 µm.

In an exemplary implementation mode, a ratio of the first distance to the second distance is 0.4 to 0.5.

In an exemplary implementation mode, the first distance ranges from 5.5 µm to 6.5 µm and the second distance ranges from 12.5 µm to 13.5 µm.

In an exemplary implementation mode, a ratio of the first distance to the second distance is 0.65 to 0.75.

In an exemplary implementation mode, the first distance ranges from 8.5 µm to 9.5 µm and the second distance ranges from 12.5 µm to 13.5 µm.

In an exemplary implementation mode, the two capacitor plates include a first plate and a second plate, and the pixel drive circuit further includes a first transistor, a second transistor, and a third transistor. A first electrode of the first transistor is connected to the data signal line, and a second electrode of the first transistor is connected to the first plate and a gate electrode of the second transistor, respectively. A first electrode of the third transistor is connected to the compensation signal line, and a second electrode of the third transistor is connected to the second plate and a second electrode of the second transistor respectively. A first distance is provided between an edge of the second plate close to the compensation signal line and an edge of the compensation signal line close to the second plate, and a second distance is provided between an edge of the second plate close to the data signal line and an edge of the data signal line close to the second plate.

In an exemplary implementation mode, the first transistor at least includes a first active layer, and the first active layer and the second plate are of an interconnected integral structure.

In an exemplary implementation mode, the pixel drive circuit is further connected to a first power supply line extending along the pixel column direction; the at least one repetition unit includes one compensation signal line, two first power supply lines, and four data signal lines. The one compensation signal line is located in middle of the at least one repetition unit in the pixel row direction, the two first power supply lines are located on two sides of the repetition unit in the pixel row direction, two data signal lines of the four data signal lines are located on a side of one of the first power supply lines close to the compensation signal line, and the other two data signal lines of the four data signal lines are located on a side of the other of the first power supply lines close to the compensation signal line.

In an exemplary implementation mode, the two first power supply lines include a first first power supply line and a second first power supply line sequentially disposed along the pixel row direction. The four data signal lines include a first data signal line, a second data signal line, a third data signal line, and a fourth data signal line sequentially disposed along the pixel row direction. The first data signal line is located on a side of the first first power supply line close to the compensation signal line, and the second data signal line is located on a side of the first data signal line close to the compensation signal line. The two capacitor plates are disposed between the second data signal line and the compensation signal line. A first distance is provided between an edge of a capacitor plate close to the compensation signal line and an edge of the compensation signal line close to the capacitor plate, and a second distance is provided between an edge of the capacitor plate close to the second data signal line and an edge of the second data signal line close to the capacitor plate. The fourth data signal line is located on a side of the second first power supply line close to the compensation signal line. The third data signal line is located on a side of the fourth data signal line close to the compensation signal line. The two capacitor plates are disposed between the third data signal line and the compensation signal line. A first distance is provided between an edge of a capacitor plate close to the compensation signal line and an edge of the compensation signal line close to the capacitor plate, and a second distance is provided between an edge of the capacitor plate close to the third data signal line and an edge of the third data signal line close to the capacitor plate.

In an exemplary implementation mode, the pixel drive circuit is further connected to a first power supply line extending along the pixel column direction; the at least one repetition unit includes two compensation signal lines, two first power supply lines, and four data signal lines. The four data signal lines are located in middle of the at least one repetition unit in the pixel row direction, the two compensation signal lines are located on two sides of the at least one repetition unit in the pixel row direction, and the two first power supply lines are respectively located on a side of the four data signal lines close to a compensation signal line.

In an exemplary implementation mode, the two compensation signal lines include a first compensation signal line and a second compensation signal line sequentially disposed along the pixel row direction. The two first power supply lines include a first first power supply line and a second first power supply line sequentially disposed along the pixel row direction. The four data signal lines include a first data signal line, a second data signal line, a third data signal line, and a fourth data signal line sequentially disposed along the pixel row direction. The first first power supply line is located on a side of the first data signal line close to the first compensation signal line. The two capacitor plates are disposed between the first compensation signal line and the first first power supply line. The second first power supply line is located on a side of the fourth data signal line close to the second compensation signal line, and the two capacitor plates are disposed between the second compensation signal line and the second first power supply line.

In another aspect, the present disclosure further provides a display device, and the display device includes the display substrate described above.

In another aspect, the present disclosure further provides a method for manufacturing a display substrate, the display substrate includes multiple repetition units, at least one repetition unit includes multiple sub-pixels forming at least two pixel rows and at least two pixel columns; the method includes:
forming a pixel drive circuit in at least one sub-pixel, wherein the pixel drive circuit is connected to a data signal line and a compensation signal line extending along a pixel column direction, respectively, the data signal line is configured to provide a data signal to the pixel drive circuit, the compensation signal line is configured to provide a compensation signal to the pixel drive circuit; the pixel drive circuit at least includes a storage capacitor, the storage capacitor at least includes two capacitor plates that are stacked, the two capacitor plates are disposed between the data signal line and the compensation signal line; a first distance is provided between an edge of at least one capacitor plate in the at least one sub-pixel close to the compensation signal line and an edge of the compensation signal line close to the capacitor plate, a second distance is provided between an edge of the at least one capacitor plate close to the data signal line and an edge of the data signal line close to the capacitor plate, the first distance is less than the second distance, and the first distance and the second distance are dimensions in a pixel row direction.

Other aspects may be comprehended upon reading and understanding drawings and detailed description.

### Brief Description of Drawings

Accompanying drawings are intended to provide a further understanding of technical solutions of the present disclosure and form a part of the specification, and are used to explain the technical solutions of the present disclosure together with embodiments of the present disclosure, but do not form limitations on the technical solutions of the present disclosure. Shapes and sizes of various components in the drawings do not reflect actual scales, but are only intended to schematically illustrate contents of the present disclosure.
FIG. 1 is a schematic diagram of a structure of a display device.
FIG. 2 is a schematic diagram of a planar structure of a display substrate according to an exemplary embodiment of the present disclosure.
FIG. 3 is an equivalent circuit diagram of a pixel drive circuit in a repetition unit according to an exemplary embodiment of the present disclosure.
FIG. 4 is a schematic diagram of a structure of a drive circuit layer in a display substrate according to an embodiment of the present disclosure.
FIG. 5 is a schematic diagram of a display substrate after a pattern of a first conductive layer is formed according to the present disclosure.
FIG. 6A and 6B are schematic diagrams of a display substrate after a pattern of a second conductive layer is formed according to the present disclosure.
FIGs. 7A, 7B, and 7C are schematic diagrams of a display substrate after a pattern of a semiconductor layer is formed according to the present disclosure.
FIG. 8 is a schematic diagram of a display substrate after a pattern of a second insulating layer is formed according to the present disclosure.
FIG. 9A and FIG. 9B are schematic diagrams of a display substrate after a pattern of a third conductive layer is formed according to the present disclosure.
FIG. 10 is a schematic diagram of a display substrate after patterns of a third insulating layer and a planarization layer according to the present disclosure.
FIG. 11A and FIG. 11B are schematic diagrams of a display substrate after a pattern of a fourth conductive layer is formed according to the present disclosure.
FIG. 12 is a schematic diagram of a display substrate after a pattern of a pixel definition layer is formed according to the present disclosure.
FIG. 13 is a schematic diagram of a structure of a drive circuit layer in another display substrate according to an embodiment of the present disclosure.

Reference signs are described as follows.

| | | | | | |
|---|---|---|---|---|---|
| 11- | First connection electrode; | 12- | Second connection electrode; | 13- | Third connection electrode; |
| 14- | Fourth connection electrode; | 15- | Fifth connection electrode; | 16- | Sixth connection electrode; |
| 17- | Seventh connection electrode; | 18- | Eighth connection electrode; | 19- | Ninth connection electrode; |
| 20- | Tenth connection electrode; | 21- | First active layer; | 22- | Second active layer; |
| 23- | Third active layer; | 30- | Scan signal line | 31- | First gate electrode; |
| 32- | Second gate electrode; | 33- | Third gate electrode; | 51- | First power supply line; |
| 52- | Data signal line; | 53- | Compensation signal line; | 54- | Pixel drive circuit; |
| 61- | First plate; | 62- | Second plate; | 63- | First electrode; |
| 100- | Repetition unit; | | | | |

### Detailed Description

To make objectives, technical solutions, and advantages of the present disclosure clearer, the embodiments of the present disclosure will be described in detail below with reference to the accompanying drawings. Implementation modes may be implemented in a plurality of different forms. Those of ordinary skills in the art may easily understand such a fact that implementation modes and contents may be transformed into various forms without departing from the purpose and scope of the present disclosure. Therefore, the present disclosure should not be explained as being limited to the contents recorded in the following implementation modes only. The embodiments and features in the embodiments of the present disclosure may be randomly combined with each other if there is no conflict.

Scales of the drawings in the present disclosure may be used as a reference in actual processes, but are not limited thereto. For example, a width-length ratio of a channel, a thickness and spacing of each film layer, and a width and spacing of each signal line may be adjusted according to actual needs. A quantity of pixels in a display substrate and a quantity of sub-pixels in each pixel are not limited to numbers shown in the drawings. The drawings described in the present disclosure are schematic structural diagrams only, and one implementation mode of the present disclosure is not limited to shapes, numerical values, or the like shown in the drawings.

Ordinal numerals "first", "second", "third", etc., in the specification are set not to form limits in numbers but only to avoid confusion between constituent elements.

In the specification, for convenience, expressions "central", "above", "below", "front", "back", "vertical", "horizontal", "top", "bottom", "inside", "outside", etc., for indicating directional or positional relationships are used to illustrate positional relationships between the constituent elements with reference to the accompanying drawings, not to indicate or imply that involved devices or elements are required to have specific orientations or are structured and operated in the specific orientations but only to easily describe the present specification and simplify the description, and thus should not be understood as limitations on the present disclosure. The positional relationships between the constituent elements may be changed as appropriate based on a direction according to which each constituent element is described. Therefore, appropriate replacements based on situations are allowed, which is not limited to the expressions in the specification.

In the specification, unless otherwise explicitly specified and defined, terms "mounting", "coupling", and "connection" should be understood in a broad sense. For example, a connection may be a fixed connection, or a detachable connection, or an integral connection; it may be a mechanical connection or an electrical connection; it may be a direct connection, or an indirect connection through a middleware, or an internal communication between two elements. Those of ordinary skills in the art may understand specific meanings of the above terms in the present disclosure according to specific situations.

In the specification, a transistor refers to an element that at least includes three terminals, i.e., a gate electrode, a drain electrode, and a source electrode. The transistor has a channel region between the drain electrode (drain electrode terminal, drain region, or drain) and the source electrode (source electrode terminal, source region, or source), and a current can flow through the drain electrode, the channel region, and the source electrode. **It** is to be noted that in the specification, the channel region refers to a region through which a current mainly flows.

In the specification, a first electrode may be a drain electrode, and a second electrode may be a source electrode. Or, the first electrode may be a source electrode, and the second electrode may be a drain electrode. In a case that transistors with opposite polarities are used, or in a case that a direction of a current changes during operation of a circuit, or the like, functions of the "source electrode" and the "drain electrode" are sometimes interchangeable. Therefore, the "source electrode" and the "drain electrode", as well as a "source electrode" and a "drain electrode", are interchangeable in the specification.

In the specification, an "electrical connection" includes a case that constituent elements are connected together through an element with a certain electrical action. The "element with a certain electrical action" is not particularly limited as long as electrical signals between the connected constituent elements may be sent and received. Examples of the "element with a certain electrical action" not only include an electrode and a wiring, but also include a switching element such as a transistor, a resistor, an inductor, a capacitor, other elements with various functions, etc.

In the specification, "parallel" refers to a state in which an angle formed by two straight lines is above -10° and below 10°, and thus may include a state in which the angle is above -5° and below 5°. In addition, "perpendicular" refers to a state in which an angle formed by two straight lines is above 80° and below 100°, and thus may include a state in which the angle is above 85° and below 95°.

In the specification, a "film" and a "layer" are interchangeable. For example, a "conductive layer" may be replaced with a "conductive film" sometimes. Similarly, an "insulating film" may be replaced with an "insulating layer" sometimes.

A triangle, rectangle, trapezoid, pentagon, or hexagon, or the like in the specification is not strictly defined, and it may be an approximate triangle, rectangle, trapezoid, pentagon, or hexagon, or the like. There may be some small deformations caused by tolerance, and there may be a chamfer, an arc edge, deformation, etc.

In the present disclosure, "about" means that a boundary is not defined so strictly and numerical values within process and measurement error ranges are allowed.

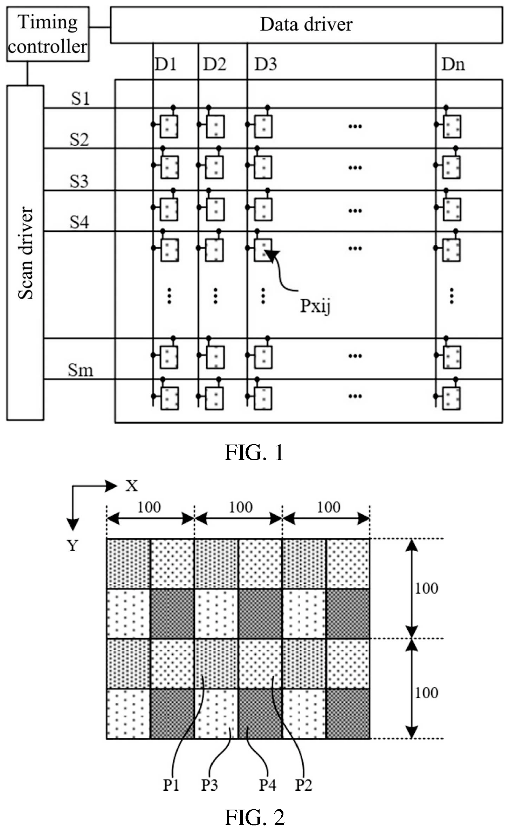

FIG. 1 is a schematic diagram of a structure of a display device. As shown in FIG. 1, an OLED display device may include a timing controller, a data driver, a scan driver and a pixel array. The timing controller is connected to the data driver and the scan driver respectively, the data driver is connected to a plurality of data signal lines (D1 to Dn) respectively, and the scan driver is connected to a plurality of scan signal lines (S1 to Sm) respectively. The pixel array may include a plurality of sub-pixels Pxij. Each sub-pixel Pxij may be connected to a corresponding data signal line and a corresponding scan signal line, wherein i and j may be natural numbers. At least one sub-pixel Pxij may at least include a circuit unit and a light emitting unit. The circuit unit may at least include a pixel drive circuit connected to a scan signal line and a data signal line respectively. The light emitting unit may at least include a light emitting device connected to the pixel drive circuit of the circuit unit, and the sub-pixel PXij may refer to a sub-pixel in which a pixel drive circuit is connected to an i-th scan signal line and a j-th data signal line. In an exemplary implementation mode, the timing controller may provide a control signal and a gray-scale value suitable for the specification of the data driver to the data driver, and may provide a scan start signal, a clock signal and the like suitable for the specification of the scan driver to the scan driver. The data driver may generate data voltages to be provided to the data signal lines D1, D2, D3, ..., and Dn using the grayscale value and the control signal that are received from the timing controller. For example, the data driver may sample the grayscale value using the clock signal and apply a data voltage corresponding to the grayscale value to the data signal lines D1 to Dn by taking a pixel row as a unit, wherein n may be a natural number. The scan driver may generate scan signals to be provided to the scan signal lines S1, S2, S3, ..., and Sm by receiving the clock signal and the scan start signal from the timing controller. For example, the scan driver may sequentially provide a scan signal with an on-level pulse to the scan signal lines S1 to Sm. For example, the scan driver may be constructed in a form of a shift register and generate a scan signal by sequentially transmitting the scan start signal provided in a form of an on-level pulse to a next-stage circuit under control of the clock signal, wherein m may be a natural number. In an exemplary implementation mode, the pixel array may be arranged on a display substrate.

An exemplary embodiment of the present disclosure provides a display substrate including a plurality of repetition units. At least one repetition unit includes a plurality of sub-pixels forming at least two pixel rows and at least two pixel columns. At least one sub-pixel includes a pixel drive circuit, the pixel drive circuit is connected to a data signal line and a compensation signal line extending along a pixel column direction respectively. The data signal line is configured to provide a data signal to the pixel drive circuit. The compensation signal line is configured to provide a compensation signal to the pixel drive circuit. The pixel drive circuit at least includes a storage capacitor, and the storage capacitor at least includes two capacitor plates that are stacked. The two capacitor plates are disposed between the data signal line and the compensation signal line. A first distance is provided between an edge of at least one capacitor plate in the at least one sub-pixel close to the compensation signal line and an edge of the compensation signal line close to the capacitor plate, a second distance is provided between an edge of the capacitor plate close to the data signal line and an edge of the data signal line close to the capacitor plate. The first distance is less than the second distance, and the first distance and the second distance are dimensions in a pixel row direction.

In an exemplary implementation mode, a ratio of the first distance to the second distance is 0.35 to 0.75.

In an exemplary implementation mode, a ratio of the first distance to the second distance is 0.6 to 0.7.

In another exemplary implementation mode, a ratio of the first distance to the second distance is 0.4 to 0.5.

In yet another exemplary implementation mode, a ratio of the first distance to the second distance is 0.65 to 0.75.

In an exemplary implementation mode, the pixel drive circuit is further connected to a first power supply line extending along a second direction. The at least one repetition unit includes one compensation signal line, two first power supply lines, and four data signal lines. The one compensation signal line is located in the middle of the repetition unit in a first direction, the two first power supply lines are located on two sides of the repetition unit in the first direction, two data signal lines of the four data signal lines are located on a side of one first power supply line close to the compensation signal line, and the other two data signal lines of the four data signal lines are located on a side of the other first power supply line close to the compensation signal line.

In an exemplary implementation mode, the two first power supply lines include a first first power supply line and a second first power supply line sequentially disposed along the first direction, and the four data signal lines include a first data signal line, a second data signal line, a third data signal line, and a fourth data signal line sequentially disposed along the first direction. The first data signal line is located on a side of the first first power supply line close to the compensation signal line, the second data signal line is located on a side of the first data signal line close to the compensation signal line. Two capacitor plates are disposed between the second data signal line and the compensation signal line, a first distance is provided between an edge of a capacitor plate close to the compensation signal line and an edge of the compensation signal line close to the capacitor plate, a second distance is provided between an edge of the capacitor plate close to the second data signal line and an edge of the second data signal line close to the capacitor plate. The fourth data signal line is located on a side of the second first power supply line close to the compensation signal line, the third data signal line is located on a side of the fourth data signal line close to the compensation signal line, two capacitor plates are disposed between the third data signal line and the compensation signal line, a first distance is provided between an edge of a capacitor plate close to the compensation signal line and an edge of the compensation signal line close to the capacitor plate, a second distance is provided between an edge of the capacitor plate close to the third data signal line and an edge of the third data signal line close to the capacitor plate.

In an exemplary implementation mode, the pixel drive circuit is further connected to a first power supply line extending along the second direction. The at least one repetition unit includes two compensation signal lines, two first power supply lines, and four data signal lines. The four data signal lines are located in the middle of the at least one repetition unit in the first direction, the two compensation signal lines are located on two sides of the at least one repetition unit in the first direction, and the two first power supply lines are respectively located on a side of the four data signal lines close to the compensation signal line.

In an exemplary implementation mode, the two compensation signal lines include a first compensation signal line and a second compensation signal line sequentially disposed along the first direction. The two first power supply lines include a first first power supply line and a second first power supply line sequentially disposed along the first direction. The four data signal lines include a first data signal line, a second data signal line, a third data signal line, and a fourth data signal line sequentially disposed along the first direction. The first first power supply line is located on a side of the first data signal line close to the first compensation signal line, and two capacitor plates are disposed between the first compensation signal line and the first first power supply line. The second first power supply line is located on a side of the fourth data signal line close to the second compensation signal line, and two capacitor plates are disposed between the second compensation signal line and the second first power supply line.

The display substrate in the present disclosure is illustrated with examples below through some exemplary embodiments.

FIG. 2 is a schematic diagram of a planar structure of a display substrate according to an exemplary embodiment of the present disclosure. As shown in FIG. 2, in an exemplary implementation mode and in a direction parallel to the display substrate, the display substrate may include a plurality of repetition units 100. At least one repetition unit 100 may include a plurality of sub-pixels forming at least two pixel rows and at least two pixel columns. In an exemplary implementation mode, the repetition units are basic units constituting the display substrate, and the display substrate is constructed by repeating and continuously disposing the repetition units along at least one direction. That is, the display substrate is formed by splicing a plurality of repetition units.

In an exemplary implementation mode, a repetition unit 100 may include four sub-pixels, the four sub-pixels may include a first sub-pixel P1 that emits a first color light, a second sub-pixel P2 that emits a second color light, a third sub-pixel P3 that emits a third color light, and a fourth sub-pixel P4 that emits a fourth color light. The four sub-pixels may be arranged in a square so that an aperture ratio and a light transmission area can be effectively increased.

In an exemplary implementation mode, in at least one repetition unit 100, the second sub-pixel P2 may be disposed on a side of the first sub-pixel P1 in a first direction X, the third sub-pixel P3 may be disposed on a side of the first sub-pixel P1 in a second direction Y, the fourth sub-pixel P4 may be disposed on a side of the third sub-pixel P3 in the first direction X, a plurality of sub-pixels sequentially disposed along the first direction X may be referred to as a pixel row, a plurality of sub-pixels sequentially disposed along the second direction Y may be referred to as a pixel column, a plurality of pixel rows and a plurality of pixel columns constitute a pixel array arranged in an array, and the first direction X intersects with the second direction Y.

In an exemplary implementation mode, the first sub-pixel P1 may be a red sub-pixel (R) emitting red light, the second sub-pixel P2 may be a blue sub-pixel (B) emitting blue light, the third sub-pixel P3 may be a white sub-pixel (W) emitting white light, and the fourth sub-pixel P4 may be a green sub-pixel (G) emitting green light. In some possible implementation modes, an arrangement mode of RBWG may be adjusted according to actual needs, and the present disclosure is not specifically limited thereto.

In an exemplary implementation mode, in a direction perpendicular to the display substrate, the display substrate may at least include a drive circuit layer provided on the base substrate and a light emitting structure layer provided on a side of the drive circuit layer away from the base substrate. In at least one repetition unit, the drive circuit layer may include a plurality of circuit units. A circuit unit may at least include a pixel drive circuit, and the pixel drive circuit is connected to a scan signal line, a data signal line and the like respectively. The pixel drive circuit is configured to receive a data voltage transmitted by the data signal line and output a corresponding current to a light emitting device under control of the scan signal line. The light emitting structure layer may include a plurality of light emitting units, and a light emitting unit may include at least a light emitting device. The light emitting device is connected to a pixel drive circuit of a circuit unit of a sub-pixel in which the light emitting device is located, and the light emitting device is configured to emit light with corresponding brightness in response to a current output by the pixel drive circuit of the sub-pixel in which the light emitting device is located.

In another exemplary implementation mode, in a direction perpendicular to the display substrate, the display substrate may at least include a drive circuit layer provided on the base substrate, a color filter structure layer provided on a side of the drive circuit layer away from the base substrate, and a light emitting structure layer provided on a side of the color filter structure layer away from the base substrate. In at least one repetition unit, the color filter structure layer may include a plurality of color filter units. A color filter unit may at least include a color filter layer, and the color filter layer is configured to enable a corresponding sub-pixel to emit light of a desired color.

In an exemplary implementation mode, a circuit unit mentioned in the present disclosure refers to a region divided by a pixel drive circuit. A color film unit mentioned in the present disclosure refers to a region divided by a color filter layer. A light emitting unit mentioned in the present disclosure refers to a region divided according to a light emitting device. Positions of an orthographic projection of the circuit unit on the base substrate, an orthographic projection of the color filter layer on the base substrate, and an orthographic projection of the light emitting unit on the base substrate may or may not correspond to each other.

In an exemplary embodiment of the present disclosure, positions of an orthographic projection of a circuit unit on the base substrate, an orthographic projection of a color filter layer on the base substrate, and an orthographic projection of a light emitting unit on the base substrate are in one-to-one correspondence. The circuit unit, the color film unit, and the light emitting unit constitute a sub-pixel, so a sub-pixel is uniformly used to refer to a circuit unit, a color film unit, and a light emitting unit in the following.

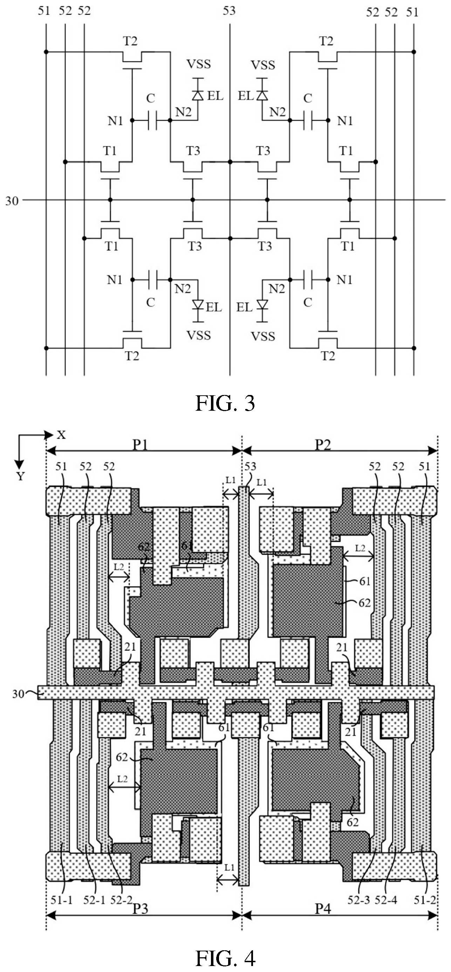

FIG. 3 is an equivalent circuit diagram of a pixel drive circuit in a repetition unit according to an exemplary embodiment of the present disclosure. As shown in FIG. 3, at least one repetition unit may include four pixel drive circuits, the four pixel drive circuits may be arranged in a square, and the pixel drive circuits may be of a 3T1C structure.

In an exemplary implementation mode, at least one pixel drive circuit may include three transistors (a first transistor T1, a second transistor T2, and a third transistor T3) and one storage capacitor C. The pixel drive circuit is connected to a scan signal line 30, a first power supply line 51, a data signal line 52, and a compensation signal line 53 respectively.

In an exemplary implementation mode, each pixel drive circuit may include a first node N1 and a second node N2. The first node N1 is connected to a second electrode of the first transistor T1, a gate electrode of the second transistor T2 and a first end of the storage capacitor C respectively, and the second node N2 is connected to a second electrode of the second transistor T2, a second electrode of the third transistor T3 and a second end of the storage capacitor C respectively.

In an exemplary implementation, the first end of the storage capacitor C is connected to the first node N1, the second end of the storage capacitor C is connected to the second node N2, and the storage capacitor C is configured to store a potential of the gate electrode of the second transistor T2.

In an exemplary implementation mode, the first transistor T1 is a switch transistor, the second transistor T2 is a drive transistor, and the third transistor T3 is a compensation transistor.

In an exemplary implementation mode, a gate electrode of the first transistor T1 is connected to the scan signal line 30, a first electrode of the first transistor T1 is connected to the data signal line 52, and a second electrode of the first transistor T1 is connected to the first node N1. When a turned-on signal is applied to the scan signal line 30, the first transistor T1 inputs a data signal of the data signal line 52 to the gate electrode of the second transistor T2.

In an exemplary implementation mode, the gate electrode of the second transistor T2 is connected to the first node N1, a first electrode of the second transistor T2 is connected to the first power supply line 51, and the second electrode of the second transistor T2 is connected to the second node N2. The second transistor T2 generates a corresponding current at the second electrode of the second transistor T2 under control of the data signal received by the gate electrode of the second transistor T2.

In an exemplary implementation mode, a gate electrode of the third transistor T3 is connected to the scan signal line 30, a first electrode of the third transistor T3 is connected to the compensation signal line 53, and a second electrode of the third transistor T3 is connected to the second node N2. When a turned-on signal is applied to the scan signal line 30, the third transistor T3 extracts a threshold voltage Vth and a migration rate of the second transistor T2 in response to a compensation timing, to compensate the threshold voltage Vth.

In an exemplary implementation mode, in a pixel drive circuit of at least one sub-pixel, the gate electrode of the first transistor T1 and the gate electrode of a third transistor T3 are connected to a same scan signal line 30.

In an exemplary implementation mode, in a plurality of pixel drive circuits of at least one pixel row, gate electrodes of a plurality of first transistors T1 and gate electrodes of a plurality of third transistors T3 are connected to a same scan signal line 30.

In an exemplary implementation mode, in a plurality of pixel drive circuits of at least one repetition unit, gate electrodes of a plurality of first transistors T1 and gate electrodes of a plurality of third transistors T3 are connected to a same scan signal line 30.

In an exemplary implementation mode, a light emitting device EL may be an OLED including a first electrode, an organic emitting layer, and a second electrode which are stacked, or may be a Quantum dot Light Emitting Diode (QLED) including a first electrode, a quantum dot emitting layer, and a second electrode which are stacked. A first electrode of the light emitting device EL is connected to the second node N2, a second electrode of the light emitting device EL is connected to a second power supply line VSS, and the light emitting device EL emits light with corresponding brightness in response to a current of the second electrode of the second transistor T2. In an exemplary implementation mode, the first electrode may be an anode, and the second electrode may be a cathode; or, the first electrode may be a cathode and the second electrode may be an anode.

In an exemplary implementation mode, a signal of the first power supply line 51 is a high-level signal continuously provided, and a signal of the second power supply line VSS is a low-level signal continuously provided.

In an exemplary implementation mode, the first transistor T1 to the third transistor T3 may be P-type transistors, or may be N-type transistors. Use of a same type of transistors in a pixel drive circuit may simplify a process flow, reduce a process difficulty of a display panel, and improve a product yield. In some possible implementation modes, the first transistor T1 to the third transistor T3 may include a P-type transistor and an N-type transistor.

In an exemplary implementation mode, for the first transistor T1 to the third transistors T3, low temperature poly-silicon thin film transistors may be used, oxide thin film transistors may be used, or a low temperature poly-silicon thin film transistor and an oxide thin film transistor may be used. An active layer of a low temperature poly silicon thin film transistor is made of Low Temperature Poly Silicon (LTPS for short), and an active layer of an oxide thin film transistor is made of an oxide semiconductor (Oxide). The low temperature poly-silicon thin film transistor has advantages, such as a high mobility and fast charging, and the oxide thin film transistor has advantages, such a low leakage current. The low temperature poly-silicon thin film transistor and the oxide thin film transistor are integrated on one display substrate, that is, an LTPS+Oxide (LTPO for short) display substrate, so that advantages of the low temperature poly-silicon thin film transistor and the oxide thin film transistor may be utilized, low-frequency drive may be achieved, power consumption may be reduced, and a display quality may be improved.

FIG. 4 is a schematic diagram of a structure of a drive circuit layer in a display substrate according to an exemplary embodiment of the present disclosure, illustrating a structure of a pixel drive circuit in a repetition unit (four sub-pixels) in a bottom emission display substrate. In an exemplary implementation mode, at least one repetition unit may include a first sub-pixel P1, a second sub-pixel P2, a third sub-pixel P3, and a fourth sub-pixel P4 arranged in a square, each sub-pixel includes a pixel drive circuit.

In an exemplary implementation mode, at least one repetition unit may include one scan signal line 30, two first power supply lines 51, four data signal lines 52, and one compensation signal line 53, the aforementioned signal lines are respectively connected to a pixel drive circuit in a corresponding sub-pixel. The scan signal line 30 is configured to provide a scan signal to the pixel drive circuit, the first power supply lines 51 are configured to provide a power supply signal to the pixel drive circuit, the data signal lines 52 are configured to provide a data signal to the pixel drive circuit, and the compensation signal line 53 is configured to provide a compensation signal to the pixel drive circuit.

In an exemplary implementation mode, the scan signal line 30 may be in a shape of a line with a main body portion extending along the first direction X (the pixel row direction), and the first power supply lines 51, the data signal lines 52, and the compensation signal line 53 may each be in a shape of a line with a main body portion extending along the second direction (the pixel column direction), wherein the first direction X intersects with the second direction Y. In an exemplary implementation mode, the scan signal line 30 may be disposed in middle of the repetition unit in the second direction Y, the one compensation signal line 53 may be located in middle of the repetition unit in the first direction X, the two first power supply lines 51 may be located on two sides of the repetition unit in the first direction X , the four data signal lines 52 and the compensation signal line 53 may be located between the two first power supply lines 51, two data signal lines 52 of the four data signal lines 52 may be located on a side of one first power supply line 51 close to the compensation signal line 53, and the other two data signal lines 52 of the four data signal lines 52 may be located on a side of the other first power supply line 51 close to the compensation signal line 53. Thus, the scan signal line 30 extending along the first direction X defines two pixel rows and the one compensation signal line 53 extending along the second direction Y may define two pixel columns, which forms a first sub-pixel P1, a second sub-pixel P2, a third sub-pixel P3, and a fourth sub-pixel P4 of a repetition unit.

In an exemplary implementation mode, in at least one repetition unit, the first sub-pixel P1 and the third sub-pixel P3 may be mirror-symmetric with respect to the scan signal line 30, the second sub-pixel P2 and the fourth sub-pixel P4 may be mirror-symmetric with respect to the scan signal line 30, the first sub-pixel P1 and the second sub-pixel P2 may be mirror-symmetric with respect to the compensation signal line 53, and the third sub-pixel P3 and the fourth sub-pixel P4 may be mirror-symmetric with respect to the compensation signal line 53.

In an exemplary implementation mode, the pixel drive circuit of at least one sub-pixel may include a first transistor, a second transistor, a third transistor, and a storage capacitor. Each transistor may include an active layer, a gate electrode, a first electrode, and a second electrode. The storage capacitor may include a first plate 61 and a second plate 62 as capacitance plates. In an exemplary implementation mode, a first electrode of the first transistor is connected to a data signal line 52, a second electrode of the first transistor is connected to a gate electrode of the second transistor and the second plate 62 of the storage capacitor respectively. A first electrode of the second transistor is connected to a first power supply line, a first electrode of the third transistor is connected to the compensation signal line 53, and a second electrode of the third transistor is connected to a second electrode of the second transistor and the first plate 61 of the storage capacitor respectively.

In an exemplary implementation mode, in at least one sub-pixel, the first plate 61 and the second plate 62 may be disposed between the data signal line 52 and the compensation signal line 53.

In an exemplary implementation mode, the two first power supply lines 51 in at least one repetition unit may include a first first power supply line 51-1 and a second first power supply line 51-2 sequentially disposed along the first direction X. The first first power supply line 51-1 may be disposed on a side of the repetition unit in a direction opposite to the first direction X, and the second first power supply line 51-2 may be disposed on a side of the repetition unit in the first direction X. The four data signal lines 52 in the at least one repetition unit may include a first data signal line 52-1, a second data signal line 52-2, a third data signal line 52-3, and a fourth data signal line 52-4 sequentially disposed along the first direction X. The first data signal line 52-1 and the second data signal line 52-2 may be disposed between the first first power supply line 51-1 and the compensation signal line 53, and the third data signal line 52-3 and the fourth data signal line 52-4 may be disposed between the second first power supply line 51-2 and the compensation signal line 53.

In an exemplary implementation mode, the first data signal line 52-1 may be located on a side of the first first power supply line 51-1 close to the compensation signal line 53, the second data signal line 52-2 may be located on a side of the first data signal line 52-1 close to the compensation signal line 53, and the first plate 61 and the second plate 62 may be disposed between the second data signal line 52-2 and the compensation signal line 53. The fourth data signal line 52-4 may be located on a side of the second first power supply line 51-2 close to the compensation signal line 53, the third data signal line 52-3 may be located on a side of the fourth data signal line 52-4 close to the compensation signal line 53, and the first plate 61 and the second plate 62 may be disposed between the third data signal line 52-3 and the compensation signal line 53.

In an exemplary implementation mode, in at least one sub-pixel, for at least one capacitor plate of the first plate 61 and the second plate 62, a first distance L1 is provided between an edge of a capacitor plate close to the compensation signal line 53 and an edge of the compensation signal line 53 close to the capacitor plate, and a second distance L2 is provided between an edge of the capacitor plate close to the data signal line 52 and an edge of the data signal line 52 close to the capacitor plate. The first distance L1 may be less than the second distance L2, and the first distance L1 and the second distance L2 may be dimensions in the first direction X.

In an exemplary implementation mode, in at least one sub-pixel, a ratio of the first distance L1 to the second distance L2 may be 0.35 to 0.75.

As shown in FIG. 4, for a second plate 62 in the first sub-pixel P1, a first distance L1 is provided between an edge of the second plate 62 close to the compensation signal line 53 and an edge of the compensation signal line 53 close to the second plate 62, and a second distance L2 is provided between an edge of the second plate 62 close to the second data signal line 52-2 and an edge of the second data signal line 52-2 close to the second plate 62, and a ratio of the first distance L1 to the second distance L2 may be 0.6 to 0.7.

In an exemplary implementation mode, in the first sub-pixel P1, the first distance L1 may be about 5.5 µm to 6.5 µm, and the second distance L2 may be about 8.5 µm to 9.5 µm. For example, the first distance L1 may be about 6 µm, and the second distance L2 may be about 9 µm.

As shown in FIG. 4, for a second plate 62 in the second sub-pixel P2, a first distance L1 is provided between an edge of the second plate 62 close to the compensation signal line 53 and an edge of the compensation signal line 53 close to the second plate 62, a second distance L2 is provided between an edge of the second plate 62 close to the third data signal line 52-3 and an edge of the third data signal line 52-3 close to the second plate 62, and a ratio of the first distance L1 to the second distance L2 may be 0.4 to 0.5.

In an exemplary implementation mode, in the second sub-pixel P2, the first distance L1 may be about 5.5 µm to 6.5 µm, and the second distance L2 may be about 12.5 µm to 13.5 µm. For example, the first distance L1 may be about 6 µm, and the second distance L2 may be about 13 µm.

As shown in FIG. 4, for a second plate 62 in the third sub-pixel P3, a first distance L1 is provided between an edge of the second plate 62 close to the compensation signal line 53 and an edge of the compensation signal line 53 close to the second plate 62, a second distance L2 is provided between an edge of the second plate 62 close to the second data signal line 52-2 and an edge of the second data signal line 52-2 close to the second plate 62, and a ratio of the first distance L1 to the second distance L2 may be 0.65 to 0.75.

In an exemplary implementation mode, in the third sub-pixel P3, the first distance L1 may be about 8.5 µm to 9.5 µm, and the second distance L2 may be about 12.5 µm to 13.5 µm. For example, the first distance L1 may be about 9 µm, and the second distance L2 may be about 13 µm.

In an exemplary implementation mode, the first transistor of each sub-pixel may at least include a first active layer 21, and the first active layer 21 and the second plate 62 may be of an interconnected integral structure.

Exemplary description is made below through a manufacturing process of a display substrate. A "patterning process" mentioned in the present disclosure includes photoresist coating, mask exposure, development, etching, photoresist stripping, and the like for a metal material, an inorganic material, or a transparent conductive material, and includes organic material coating, mask exposure, development, and the like for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process. "A and B are provided in a same layer" in the present disclosure means that A and B are formed simultaneously through a same patterning process, and a "thickness" of a film layer is a dimension of the film layer in a direction perpendicular to a display substrate. In an exemplary embodiment of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A overlaps with the boundary of the orthographic projection of B.

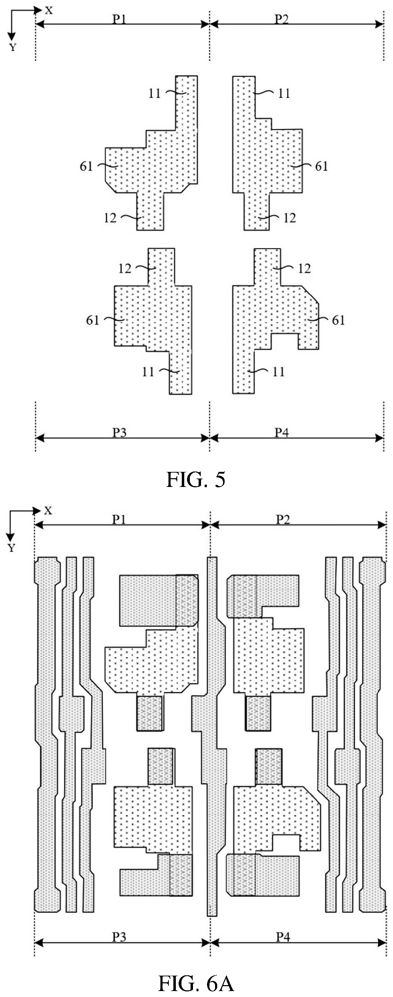

In an exemplary implementation, taking four sub-pixels (a first sub-pixel P1, a second sub-pixel P2, a third sub-pixel P3, and a fourth sub-pixel P4) of one repetition unit as an example, a manufacturing process of the display substrate of the embodiment may include following operations.
(1) Forming a pattern of a first conductive layer. In an exemplary implementation mode, forming the pattern of the first conductive layer includes: depositing a first conductive thin film on a base substrate, patterning the first conductive thin film through a patterning process, to form the pattern of the first conductive layer on the base substrate, as shown in FIG. 5.

In an exemplary implementation mode, the first conductive layer of each sub-pixel in the display substrate may at least include a first connection electrode 11, a second connection electrode 12, and a first plate 61 of a storage capacitor.

In an exemplary implementation mode, the first plate 61 may be in a shape of a rectangle, corners of the rectangle may be chamfered, the first plate 61 may serve as a transparent plate of a transparent storage capacitor, and the first plate 61 is configured to form a transparent storage capacitor with a second plate to be formed subsequently.

In an exemplary implementation mode, the first connection electrode 11 and the second connection electrode 12 may be on two sides of the first plate 61 in the second direction Y respectively.

In an exemplary implementation mode, in the first sub-pixel P1 and the second sub-pixel P2, the first connection electrode 11 may be disposed on a side of the first plate 61 in a direction opposite to the second direction Y, and the second connection electrode 12 may be disposed on a side of the first plate 61 in the second direction Y. In the third sub-pixel P3 and the fourth sub-pixel P4, the first connection electrode 11 may be disposed on a side of the first plate 61 in the second direction Y, and the second connection electrode 12 may be disposed on a side of the first plate 61 in the direction opposite to the second direction Y.

In an exemplary implementation mode, the first connection electrode 11 may be in a shape of a strip with a main body portion extending along the second direction Y, a first end of the first connection electrode 11 is connected to the first plate 61, a second end of the first connection electrode 11 extends in a direction away from the second connection electrode 12, and the first connection electrode 11 is configured to be connected to a third connection electrode to be formed subsequently.

In an exemplary implementation mode, the second connection electrode 12 may be in a shape of a strip with a main body portion extending along the second direction Y, a first end of the second connection electrode 12 is connected to the first plate 61, a second end of the second connection electrode 12 extends in a direction away from the first connection electrode 11, and the second connection electrode 12 is configured to be connected to a fourth connection electrode to be formed subsequently.

In an exemplary implementation mode, in a first pixel column, an edge of the first connection electrode 11 close to a second pixel column and an edge of the first plate 61 close to the second pixel column may be substantially flush. In the second pixel column, an edge of the first connection electrode 11 close to the first pixel column and an edge of the first plate 61 close to the first pixel column may be substantially flush.

In an exemplary implementation mode, the first connection electrode 11, the second connection electrode 12, and the first plate 61 of each sub-pixel may be of an interconnected integral structure.

In an exemplary implementation mode, positions of respective patterns in the first conductive layer in the first sub-pixel P1 and position of respective patterns in the first conductive layer in the third sub-pixel P3 may be substantially mirror-symmetric with respect to a horizontal reference line. Positions of respective patterns in the first conductive layer in the second sub-pixel P2 and positions of respective patterns in the first conductive layer in the fourth sub-pixel P4 may be substantially mirror-symmetric with respect to the horizontal reference line. The positions of the respective patterns in the first conductive layer in the first sub-pixel P1 and the positions of the respective patterns in the first conductive layer in the second sub-pixel P2 may be substantially mirror-symmetric with respect to a vertical reference line. The positions of the respective patterns in the first conductive layer in the third sub-pixel P3 and the positions of the respective patterns in the first conductive layer in the fourth sub-pixel P4 may be substantially mirror-symmetric with respect to the vertical reference line. The horizontal reference line may be a straight line extending along the first direction X and bisecting a repetition unit in the second direction Y, and the vertical reference line may be a straight line extending along the second direction Y and bisecting a repetition unit in the first direction X.

In an exemplary implementation, the first conductive layer may be made of a transparent conductive material, such as Indium Tin Oxide (ITO) or Indium Zinc Oxide (IZO).

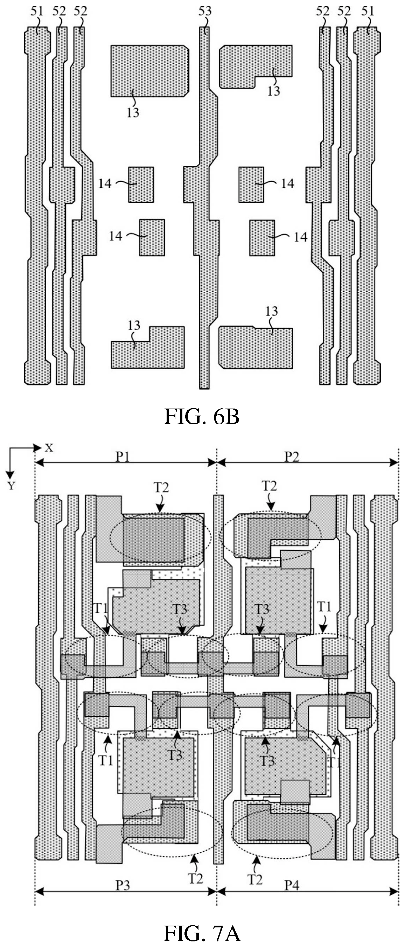

(2) Forming a pattern of a second conductive layer. In an exemplary implementation mode, forming the pattern of the second conductive layer may include: depositing a second conductive thin film on the base substrate on which the aforementioned pattern is formed, and patterning the second conductive thin film through a patterning process to form the second conductive layer, as shown in FIG. 6A and FIG. 6B, wherein FIG. 6B is a schematic diagram of the second conductive layer in FIG. 6A. In an exemplary implementation mode, the second conductive layer may be referred to as a shield layer.

In an exemplary implementation mode, a second conductive layer of each sub-pixel in the display substrate may include at least a third connection electrode 13 and a fourth connection electrode 14.

In an exemplary implementation mode, the third connection electrode 13 may be in a shape of a block (for example, a rectangle), and may be located on a side of the first plate 61 away from the second connection electrode 12. An orthographic projection of the third connection electrode 13 on the base substrate is at least partially overlapped with an orthographic projection of the first connection electrode 11 on the base substrate, and the third connection electrode 13 is directly overlapped with the first connection electrode 11. In an exemplary implementation mode, on one hand, the third connection electrode 13 is configured to be connected to a fifth connection electrode to be formed subsequently, and, on the other hand, the third connection electrode 13 is configured to shade a second transistor, so as to reduce an intensity of light irradiated on the second transistor, reduce a leakage current of the second transistor, thereby reducing an influence of illumination on characteristics of the second transistor.

In an exemplary implementation mode, the fourth connection electrode 14 may be in a shape of a block (for example, a rectangle), and may be located on a side of the first plate 61 away from the first connection electrode 11. An orthographic projection of the fourth connection electrode 14 on the base substrate is at least partially overlapped with an orthographic projection of the second connection electrode 12 on the base substrate, and the fourth connection electrode 14 is directly overlapped with the second connection electrode 12, and the fourth connection electrode 14 is configured to be connected to a sixth connection electrode to be formed subsequently.

In an exemplary implementation mode, the second conductive layer of each repetition unit in the display substrate may include at least two first power supply lines 51, four data signal lines 52, and one compensation signal line 53.

In an exemplary implementation mode, the first power supply lines 51, the data signal lines 52, and the compensation signal line 53 may each be in a shape of a straight line or in a shape of a polygonal line with a main body portion extending along the second direction Y. The compensation signal line 53 may be located in the middle of the repetition unit in the first direction X, a first first power supply line 51 may be located on a side of the repetition unit in an opposite direction of the first direction X, a second first power supply line 51 may be located on a side of the repetition unit in the first direction X, two of the four data signal lines 52 may be located between the first first power supply line 51 and the compensation signal line 53, and the other two of the four data signal lines 52 may be located between the second first power supply line 51 and the compensation signal line 53.

In an exemplary implementation mode, the first first power supply line 51 and the compensation signal line 53 may define a first pixel column, and two data signal lines 52 are disposed in the first pixel column. The second first power supply line 51 and the compensation signal line 53 may define a second pixel column, and two data signal lines 52 are disposed in the second pixel column.

In an exemplary implementation mode, positions of the two first power supply lines 51 may be substantially mirror-symmetrical with respect to a vertical reference line. Positions of two data signal lines 52 located on a side of the compensation signal line 53 in the opposite direction of the first direction X and positions of two data signal lines 52 located on a side of the compensation signal line 53 in the first direction X may be substantially mirror-symmetrical with respect to the vertical reference line. Positions of a third connection electrode 13 and a fourth connection electrode 14 in the first sub-pixel P1 and positions of a third connection electrode 13 and a fourth connection electrode 14 in the third sub-pixel P3 may be substantially mirror-symmetrical with respect to a horizontal reference line. Positions of a third connection electrode 13 and a fourth connection electrode 14 in the second sub-pixel P2 and positions of a third connection electrode 13 and a fourth connection electrode 14 in the fourth sub-pixel P4 may be substantially mirror-symmetrical with respect to the horizontal reference line.

In an exemplary implementation mode, the first power supply lines 51, the data signal lines 52, and the compensation signal line 53 may be polygonal lines with non-equal widths, and adopting polygonal lines with varying widths may not only facilitate a layout of the pixel structure, but also reduce a parasitic capacitance.

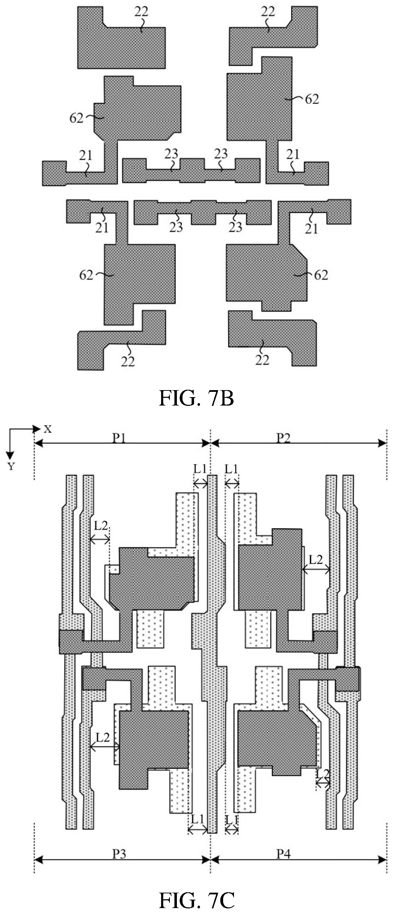

(3) Forming a pattern of a semiconductor layer. In an exemplary implementation mode, forming the pattern of the semiconductor layer may include: depositing a first insulating thin film and a semiconductor thin film sequentially on the base substrate on which the aforementioned patterns are formed, and patterning the semiconductor thin film through a patterning process to form a first insulating layer that covers the first conductive layer and the second conductive layer, and the semiconductor layer disposed on the first insulating layer, as shown in FIG. 7A and FIG. 7B, wherein FIG. 7B is a schematic diagram of the semiconductor layer in FIG. 7A.

In an exemplary implementation mode, the semiconductor layer of each sub-pixel in the display substrate may at least include a first active layer 21, a second active layer 22, a third active layer 23, and a second plate 62 of a storage capacitor. The first active layer 21 may serve as an active layer of a first transistor T1, the second active layer 22 may serve as an active layer of a second transistor T2, the third active layer 23 may serve as an active layer of a third transistor T3, the second plate 62 may serve as another transparent plate of the transparent storage capacitor, and the second plate 62 is configured to form the transparent storage capacitor with the first plate 61.

In an exemplary implementation mode, for the first sub-pixel P1 and the second sub-pixel P2, the first active layer 21 and the third active layer 23 may be provided on a side of the first plate 61 of the current sub-pixel in the second direction Y, and the second active layer 22 may be provided on a side of the first plate 61 of the current sub-pixel in the direction opposite to the second direction Y.

In an exemplary implementation mode, for the first sub-pixel P1, the first active layer 21 may be provided on a side of the current sub-pixel away from the second sub-pixel P2, and the third active layer 23 may be provided on a side of the current sub-pixel close to the second sub-pixel P2. For the second sub-pixel P2, the first active layer 21 may be provided on a side of the current sub-pixel away from the first sub-pixel P1, and the third active layer 23 may be provided on a side of the current sub-pixel close to the first sub-pixel P1.

In an exemplary implementation mode, for the third sub-pixel P3 and the fourth sub-pixel P4, the first active layer 21 and the third active layer 23 may be provided on a side of the first plate 61 of the current sub-pixel in the direction opposite to the second direction Y, and the second active layer 22 may be provided on a side of the first plate 61 of the current sub-pixel in the second direction Y.

In an exemplary implementation mode, for the third sub-pixel P3, the first active layer 21 may be provided on a side of the current sub-pixel away from the fourth sub-pixel P4, and the third active layer 23 may be provided on a side of the current sub-pixel close to the fourth sub-pixel P4. For the fourth sub-pixel P4, the first active layer 21 may be provided on a side of the current sub-pixel away from the third sub-pixel P3, and the third active layer 23 may be provided on a side of the current sub-pixel close to the third sub-pixel P3.

In an exemplary implementation mode, an active layer of each transistor may include a first region, a second region, and a channel region located between the first region and the second region.

In an exemplary implementation mode, an orthographic projection of a first region of the first active layer 21 of each sub-pixel on the base substrate is at least partially overlapped with an orthographic projection of a corresponding data signal line 52 on the base substrate, and a second region of the first active layer 21 is connected to the second plate 62.

In an exemplary implementation mode, an orthographic projection of a first region of the second active layer 22 of each sub-pixel on the base substrate is not overlapped with an orthographic projection of the third connection electrode 13 of the current sub-pixel on the base substrate, and an orthographic projection of a second region and a channel region of the second active layer 22 on the base substrate is at least partially overlapped with the orthographic projection of the third connection electrode 13 on the base substrate, so that the third connection electrode 13 serving as a shield layer can shield the channel region of the second transistor T2, avoid influence of light on the channel, and ensure electrical performance of the second transistor T2.

In an exemplary implementation mode, an orthographic projection of a first region of the third active layer 23 of each sub-pixel on the base substrate is at least partially overlapped with an orthographic projection of the compensation signal line 53 on the base substrate, and an orthographic projection of a second region of the third active layer 23 on the base substrate is at least partially overlapped with an orthographic projection of the fourth connection electrode 14 of the current sub-pixel on the base substrate.

In an exemplary implementation mode, the first region of the third active layer 23 in the first sub-pixel P1 and the first region of the third active layer 23 in the second sub-pixel P2 may be connected to each other, and the first region of the third active layer 23 in the third sub-pixel P3 and the first region of the third active layer 23 in the fourth sub-pixel P4 may be connected to each other.

In an exemplary implementation mode, the third active layer 23 in the first sub-pixel P1 and the third active layer 23 in the second sub-pixel P2 may be of an interconnected integral structure, and the third active layer 23 in the third sub-pixel P3 and the third active layer 23 in the fourth sub-pixel P4 may be of an interconnected integral structure. In the present disclosure, third transistors of two adjacent sub-pixels in a pixel row are configured to share the first region of the third active layer, which can effectively reduce a quantity of vias, reduce an occupied area of a pixel drive circuit, is beneficial to improving resolution, reduce a connection structure of vias, and simplify a manufacturing process.

In an exemplary implementation mode, the second plate 62 may be in a shape of a rectangle, corners of the rectangle may be chamfered, and the second plate 62 may be disposed between the second active layer 22 and the third active layer 23 of the current sub-pixel. An orthographic projection of the second plate 62 on the base substrate is at least partially overlapped with an orthographic projection of the first plate 61 on the base substrate, the second plate 62 may serve as a transparent intermediate plate of a transparent storage capacitor, and the first plate 61 and the second plate 62 form the transparent storage capacitor.

In an exemplary implementation mode, the second plate 62 and the first active layer 21 of each sub-pixel may be of an interconnected integral structure.

In an exemplary implementation mode, an area of an overlapping region between the orthographic projection of the first plate 61 on the base substrate and the orthographic projection of the second plate 62 on the base substrate in each sub-pixel may be substantially the same so that a capacity of the storage capacitor in each sub-pixel is substantially the same.

In an exemplary implementation mode, the semiconductor layer may be made of a metal oxide such as an oxide containing indium and tin, an oxide containing tungsten and indium, an oxide containing tungsten, indium and zinc, an oxide containing titanium and indium, an oxide containing titanium, indium and tin, an oxide containing indium and zinc, an oxide containing silicon, indium and tin, an oxide containing indium, gallium and zinc, etc. The semiconductor layer may be a single layer, two layers, or a plurality of layers.

In an exemplary implementation mode, positions of respective patterns in the semiconductor layer in the first sub-pixel P1 and position of respective patterns in the semiconductor layer in the third sub-pixel P3 may be substantially mirror-symmetric with respect to a horizontal reference line. Positions of respective patterns in the semiconductor layer in the second sub-pixel P2 and positions of respective patterns in the semiconductor layer in the fourth sub-pixel P4 may be substantially mirror-symmetric with respect to the horizontal reference line. The positions of the respective patterns in the semiconductor layer in the first sub-pixel P1 and the positions of the respective patterns in the semiconductor layer in the second sub-pixel P2 may be substantially mirror-symmetric with respect to a vertical reference line. The positions of the respective patterns in the semiconductor layer in the third sub-pixel P3 and the positions of the respective patterns in the semiconductor layer in the fourth sub-pixel P4 may be substantially mirror-symmetric with respect to the vertical reference line.

FIG. 7C is a schematic diagram of a position of a storage capacitor according to an exemplary embodiment of the present disclosure. As shown in FIG. 7C, for at least one of the first plate 61 and the second plate 62 in each sub-pixel, a first distance L1 is provided between an edge of the capacitor plate close to the compensation signal line 53 and an edge of the compensation signal line 53 close to the capacitor plate, and a second distance L2 is provided between an edge of the capacitor plate close to the data signal line 52 and an edge of the data signal line 52 close to the capacitor plate, and the first distance L1 and the second distance L2 are dimensions in the first direction X. In at least one sub-pixel, the first distance L1 may be less than the second distance L2.

In an exemplary implementation mode, the second plate 62 is taken as an example. A first distance L1 is provided between an edge of the second plate 62 close to the compensation signal line 53 and an edge of the compensation signal line 53 close to the second plate 62, and a second distance L2 is provided between an edge of the second plate 62 close to the data signal line 52 and an edge of the data signal line 52 close to the second plate 62.

In an exemplary implementation mode, in at least one sub-pixel, L1/L2 ranges from 0.35 to 0.75.

In an exemplary implementation mode, in the first sub-pixel P1, L1/L2 ranges from 0.6 to 0.7. For example, L1/L2 = 0.67.

In an exemplary implementation mode, in the first sub-pixel P1, L1 ranges from 5.5 µm to 6.5 µm, and L2 ranges from 8.5 µm to 9.5 µm. For example, L1 = 6 µm, and L2 = 9 µm.

In an exemplary implementation mode, in the second sub-pixel P2, L1/L2 ranges from 0.4 to 0.5. For example, L1/L2 = 0.46.

In an exemplary implementation mode, in the second sub-pixel P2, L1 ranges from 5.5 µm to 6.5 µm, and L2 ranges from 12.5 to 13.5 µm. For example, L1 = 6 µm, and L2 = 13 µm.

In an exemplary implementation mode, in the third sub-pixel P3, L1/L2 ranges from 0.65 to 0.75. For example, L1/L2 = 0.7.

In an exemplary implementation mode, in the third sub-pixel P3, L1 ranges from 8.5 µm to 9.5 µm, and L2 ranges from 12.5 µm to 13.5 µm. For example, L1 = 9 µm, and L2 = 13 µm.

In an exemplary implementation mode, the first distance L1 and the second distance L2 may be minimum distances, or may be average distances, which is not limited here in the present disclosure.

In an exemplary implementation mode, the first distance L1 may be a distance between the first plate 61 and the compensation signal line 53, and the second distance L2 may be a distance between the first plate 61 and the data signal line 52.

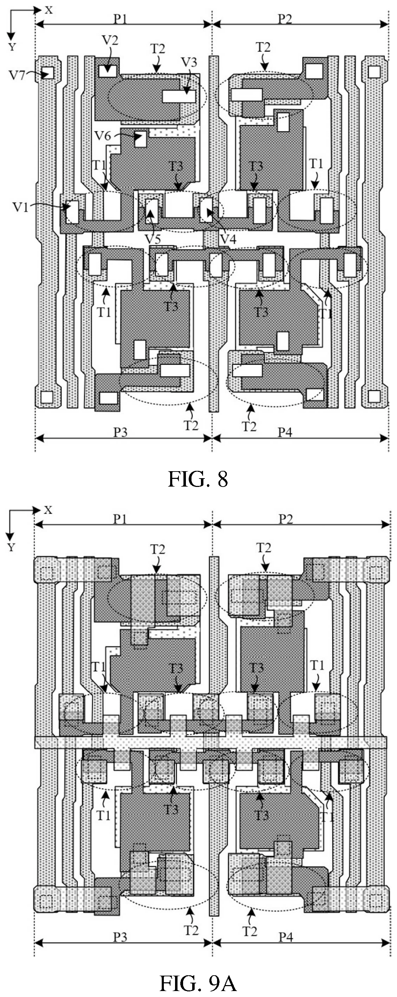

(4) Forming a pattern of a second insulating layer. In an exemplary implementation mode, forming the pattern of the second insulating layer may include: depositing a second insulating thin film on the base substrate on which the aforementioned patterns are formed, patterning the second insulating thin film through a patterning process to form the pattern of the second insulating layer that covers the semiconductor layer, wherein a plurality of vias are provided on the second insulating layer, as shown in FIG. 8.

**In** an exemplary implementation mode, a plurality of vias of each sub-pixel in the display substrate include at least: a first via V1, a second via V2, a third via V3, a fourth via V4, a fifth via V5, a sixth via V6, and a seventh via V7.

**In** an exemplary implementation mode, an orthographic projection of the first via V1 on the base substrate is within a range of orthographic projections of the first region of the first active layer 21 and a data signal line 52 on the base substrate. The first via V1 is a via of a transfer structure and includes a shallow half hole and a deep half hole. The second insulating layer in the shallow half hole is etched away to expose a surface of the first region of the first active layer 21, and the first insulating layer and the second insulating layer in the deep half hole are etched away to expose a surface of the data signal line 52, so that the via of the transfer structure composed of the two half holes simultaneously exposes the first region of the first active layer 21 and the data signal line 52. The first via V1 is configured such that a seventh connection electrode to be formed subsequently is simultaneously connected to the first region of the first active layer 21 and the data signal line 52 through the first via V1.

**In** an exemplary implementation mode, an orthographic projection of the second via V2 on the base substrate is within a range of an orthographic projection of the first region of the second active layer 22 on the base substrate, the second insulating layer in the second via V2 is etched away to expose a surface of the first region of the second active layer 22, and the second via V2 is configured such that an eighth connection electrode to be formed subsequently is connected to the first region of the second active layer 22 through the second via V2.

In an exemplary implementation mode, an orthographic projection of the third via V3 on the base substrate is within a range of orthographic projections of a second region of the second active layer 22 and the third connection electrode 13 on the base substrate. The third via V3 is a via of a transfer structure and includes a shallow half hole and a deep half hole. The second insulating layer in the shallow half hole is etched away to expose a surface of the second region of the second active layer 22, and the first insulating layer and the second insulating layer in the deep half hole are etched away to expose a surface of the third connection electrode 13, so that the via of the transfer structure composed of the two half holes simultaneously exposes the second region of the second active layer 22 and the third connection electrode 13. The third via V3 is configured such that a fifth connection electrode to be formed subsequently is simultaneously connected to the second region of the second active layer 22 and the third connection electrode 13 through the third via V3.

In an exemplary implementation mode, an orthographic projection of the fourth via V4 on the base substrate is within a range of orthographic projections of the first region of the third active layer 23 and the compensation signal line 53 on the base substrate. The fourth via V4 is a via of a transfer structure and includes a shallow half hole and a deep half hole. The second insulating layer in the shallow half hole is etched away to expose a surface of the first region of the third active layer 23, and the first insulating layer and the second insulating layer in the deep half hole are etched away to expose a surface of the compensation signal line 53, so that the via of the transfer structure composed of the two half holes simultaneously exposes the first region of the third active layer 23 and the compensation signal line 53. The fourth via V4 is configured such that a ninth connection electrode to be formed subsequently is simultaneously connected to the first region of the third active layer 23 and the compensation signal line 53 through the fourth via V4.

In an exemplary implementation mode, since first regions of the third active layers in the first sub-pixel P1 and the second sub-pixel P2 are connected to each other, and first regions of the third active layers in the third sub-pixel P3 and the fourth sub-pixel P4 are connected to each other, the first sub-pixel P1 and the second sub-pixel P2 share one fourth via V4, and the third sub-pixel P3 and the fourth sub-pixel P4 of the repetition unit share one fourth via V4. In the present disclosure, by providing adjacent sub-pixels to share one fourth via V4, a quantity of vias can be effectively reduced, an occupied area of a pixel drive circuit can be reduced, and resolution can be improved, and a via connection structure can be reduced, and a manufacturing process can be simplified.

In an exemplary implementation mode, an orthographic projection of the fifth via V5 on the base substrate is within a range of an orthographic projection of the second region of the third active layer 23 and the fourth connection electrode 14 on the base substrate. The fifth via V5 is a via of a transfer structure, which includes a shallow half hole and a deep half hole. The second insulating layer in the shallow half hole is etched away to expose a surface of the second region of the third active layer 23, and the first insulating layer and the second insulating layer in the deep half hole are etched away to expose a surface of the fourth connection electrode 14, so that the via of the transfer structure composed of the two half holes simultaneously exposes the second region of the third active layer 23 and the fourth connection electrode 14. The fifth via V5 is configured such that a sixth connection electrode to be formed subsequently is simultaneously connected to the second region of the third active layer 23 and the fourth connection electrode 14 through the fifth via V5.

In an exemplary implementation mode, an orthographic projection of the sixth via V6 on the base substrate is within a range of the orthographic projection of the second plate 62 on the base substrate, the second insulating layer in the sixth via V6 is etched away to expose a surface of the second plate 62, and the sixth via V6 is configured to connect a second gate electrode to be formed subsequently to the second plate 62 through the sixth via V6.

In an exemplary implementation mode, an orthographic projection of the seventh via V7 on the base substrate is within a range of an orthographic projection of the first power supply line 51 on the base substrate, the first insulating layer and the second insulating layer in the seventh via V7 are etched away to expose a surface of the first power supply line 51, and the seventh via V7 is configured to connect the eighth connection electrode to be formed subsequently to the first power supply line 51 through the via V7.

In an exemplary implementation mode, in a process of forming the pattern of the second insulating layer, a plurality of vias are formed by a dry etching process, and a first conductorization treatment is performed on the semiconductor layer exposed by the vias, so that the semiconductor layer exposed by the vias forms a first conductorized region. During the first conductorization process, an edge portion of the semiconductor layer covered by the second insulating layer close to a via is also conductorized, i.e., the semiconductor layer after the first conductorization extends in a direction away from the via.

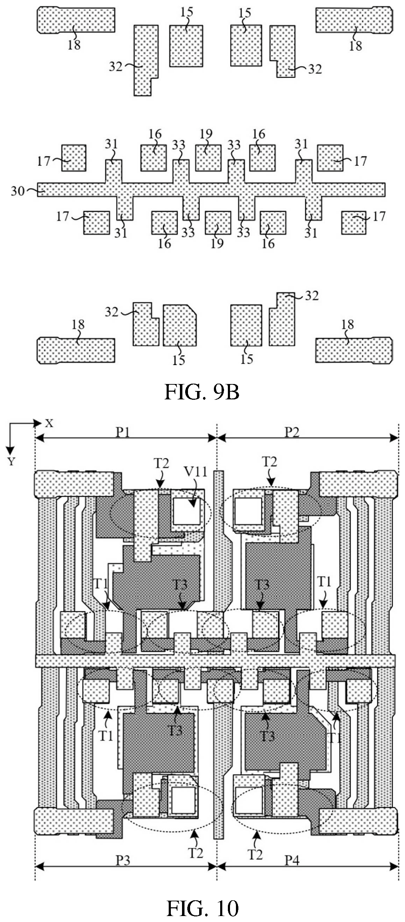

(5) Forming a pattern of a third conductive layer. In an exemplary implementation mode, forming the pattern of the third conductive layer may include: depositing a third conductive thin film on the base substrate on which the aforementioned patterns are formed, patterning the third conductive thin film through a patterning process to form the pattern of the third conductive layer on the second insulating layer, as shown in FIG. 9A and FIG. 9B, wherein FIG. 9B is a schematic diagram of the third conductive layer in FIG. 9A. In an exemplary implementation mode, the third conductive layer may be referred to as a gate metal (GT) layer.

In an exemplary implementation mode, the third conductive layer of each sub-pixel in the display substrate may at least include a fifth connection electrode 15, a sixth connection electrode 16, a seventh connection electrode 17, an eighth connection electrode 18, a ninth connection electrode 19, a scan signal line 30, a first gate electrode 31, a second gate electrode 32, and a third gate electrode 33.

In an exemplary implementation mode, the scan signal line 30 may be in a shape of a line with a main body portion extending along the first direction X and may be provided in the middle of the second direction Y of the repetition unit, i.e., between the first sub-pixel P1 with the second sub-pixel P2 and the third sub-pixel P3 with the fourth sub-pixel P4, and the scan signal line 30 is configured to simultaneously control turn-on or turn-off of all the first transistors T1 and all the third transistors T3 in the four sub-pixels of the repetition unit.

In an exemplary implementation mode, an orthographic projection of the scan signal line 30 on the base substrate is not overlapped with an orthographic projection of the first active layer 21 and the third active layer 23 on the base substrate.

In an exemplary implementation mode, the first gate electrode 31 may be in a shape of a strip extending along the second direction Y, and may be provided on a side of the scan signal line 30 close to the first active layer 21. A first end of the first gate electrode 31 is connected to the scan signal line 30, a second end of the first gate electrode 31 extends in a direction towards the first active layer 21, and an orthographic projection of the first gate electrode 31 on the base substrate is at least partially overlapped with the orthographic projection of the first active layer 21 on the base substrate. In an exemplary implementation mode, the first gate electrode 31 may serve as a gate electrode of the first transistor T1, so that the scan signal line 30 may control turn-on or turn-off of the first transistor T1.

In an exemplary implementation mode, the second gate electrode 32 may be in a shape of a strip extending along the second direction Y. A first end of the second gate electrode 32 is connected to the second plate 62 through the sixth via V6, a second end of the second gate electrode 32 extends in a direction towards the second active layer 22, and an orthographic projection of the second gate electrode 32 on the base substrate is at least partially overlapped with an orthographic projection of the second active layer 22 on the base substrate. In an exemplary implementation mode, the second gate electrode 32 may serve as a gate electrode of the second transistor T2 and may control turn-on or turn-off of the second transistor T2.

In an exemplary implementation mode, since the second gate electrode 32 is connected to the second plate 62 and the second plate 62 is connected to the second region of the first active layer 21, it is achieved that the second electrode of the first transistor T1, the gate electrode of the second transistor T2 and the second plate 62 (the first end of the storage capacitor) have a same potential, so that a first node in the pixel drive circuit is formed, and the second plate 62 has a potential of the first node in the pixel drive circuit.

In an exemplary implementation mode, the third gate electrode 33 may be in a shape of a strip extending along the second direction Y, and may be disposed on a side of the scan signal line 30 close to the third active layer 23. A first end of the third gate electrode 33 is connected to the scan signal line 30, a second end of the third gate electrode 33 extends along a direction towards the third active layer 23, and an orthographic projection of the third gate electrode 33 on the base substrate is at least partially overlapped with an orthographic projection of the third active layer 23 on the base substrate. In an exemplary implementation mode, the third gate electrode 33 may serve as a gate electrode of the third transistor T3, so that the scan signal line 30 may control turn-on or turn-off of the third transistor T3.

In an exemplary implementation mode, in one sub-pixel, one scan signal line 30 is simultaneously connected to the first gate electrode 31 and the third gate electrode 33, so that the scan signal line 30 may control turn-on or turn-off of a first transistor T1 and a third transistor T3 in one sub-pixel.

In an exemplary implementation mode, in one pixel row, one scan signal line 30 is simultaneously connected to all first gate electrodes 31 and all third transistors 33 in a plurality of sub-pixels, so that the scan signal line 30 may control turn-on or turn-off of all first transistors T1 and all third transistors T3 in one pixel row.

In an exemplary implementation mode, in one repetition unit, one scan signal line 30 is simultaneously connected to all first gate electrodes 31 and all third transistors 33 in a plurality of sub-pixels, so that the scan signal line 30 may simultaneously control turn-on or turn-off of all first transistors T1 and all third transistors T3 in the repetition unit.

In an exemplary implementation mode, the fifth connection electrode 15 may be in a shape of a block (for example, a rectangle), may be provided on a side of the second plate 62 away from the scan signal line 30, and the fifth connection electrode 15 is simultaneously connected to the second region of the second active layer 22 and the third connection electrode 13 through the third via V3.

In an exemplary implementation mode, since the fifth connection electrode 15 is simultaneously connected to the second region of the second active layer 22 and the third connection electrode 13, the third connection electrode 13 is connected to the first connection electrode 11, and the first connection electrode 11 is connected to the first plate 61, the fifth connection electrode 15 enables a second electrode of a second transistor and the first plate 61 to have a same potential. In an exemplary implementation mode, the fifth connection electrode 15 is configured to be connected to a tenth connection electrode to be formed subsequently.

In an exemplary implementation mode, the sixth connection electrode 16 may be in a shape of a block (for example, a rectangle) and may be provided on a side of the second plate 62 close to the scan signal line 30, and the sixth connection electrode 16 is simultaneously connected to the second region of the third active layer 23 and the fourth connection electrode 14 through the fifth via V5.

In an exemplary implementation mode, since the sixth connection electrode 16 is simultaneously connected to the second region of the third active layer 23 and the fourth connection electrode 14, the fourth connection electrode 14 is connected to the second connection electrode 12, and the second connection electrode 12 is connected to the first plate 61, the sixth connection electrode 16 enables a second electrode of a third transistor and the first plate 61 to have a same potential.

In an exemplary implementation mode, connection between the second electrode of the second transistor, the second electrode of the third transistor, and the first plate 61 (a second end of the storage capacitor) is achieved by the fifth connection electrode 15 and the sixth connection electrode 16, and a second node in the pixel drive circuit is formed, so that the first plate 61 has a potential of the second node in the pixel drive circuit.

In an exemplary implementation mode, since the first plate 61 has the potential of the second node in the pixel drive circuit and the second plate 62 has the potential of the first node in the pixel drive circuit, the first plate 61 with the potential of the second node and the second plate 62 with the potential of the first node form a storage capacitor.

In an exemplary implementation mode, since the first plate 61 is made of a transparent conductive material and the second plate 62 is made of a transparent metal oxide, the storage capacitor is a transparent capacitor.

In an exemplary implementation mode, the seventh connection electrode 17 may be in a shape of a block (for example, a rectangle) and may be provided between the first gate electrode 31 and the first power supply line 51, and the seventh connection electrode 17 is simultaneously connected to the first region of the first active layer 21 and the data signal line 52 through the first via V1, thereby achieving that a data signal is written to the first electrode of the first transistor T1 by the data signal line 52. In an exemplary implementation mode, each data signal line 52 may be connected to a first region of a first active layer in one sub-pixel through the first via V1, thereby achieving that data signals are written into first electrodes of four first transistors T1 in one repetition unit by four data signal lines 52, respectively.

In an exemplary implementation mode, the four data signal lines 52 may include a first data signal line, a second data signal line, a third data signal line, and a fourth data signal line. The first data signal line may be located on a side of the first power supply line 51 in a first pixel column in the first direction X, and may be connected to the first region of the first active layer in the first sub-pixel P1 through a seventh connection electrode 17. The second data signal line may be located on a side of the first data signal line in the first direction X, and may be connected to a first region of a first active layer in a third sub-pixel P3 through a seventh connection electrode 17. The third data signal line may be located on a side of the compensation signal line 53 in the first direction X, and may be connected to the first region of the first active layer in the second sub-pixel P2 through a seventh connection electrode 17. The fourth data signal line may be located on a side of the third data signal line in the first direction X, and may be connected to a first region of a first active layer in a third sub-pixel P4 through a seventh connection electrode 17.

In an exemplary implementation mode, the eighth connection electrode 18 may be in a shape of a strip extending along the first direction X and may be disposed on a side of the second plate 62 away from the scan signal line 30. A first end of the eighth connection electrode 18 is connected to the first power supply line 51 through the seventh via V7, and a second end of the eighth connection electrode 18 is connected to the first region of the second active layer 22 through the second via V2, thereby achieving that a first power supply signal is written into the first electrode of the second transistor T2 by the first power supply line 51.

In an exemplary implementation mode, a first power supply line 51 of a first pixel column may simultaneously provide a first power supply signal to pixel drive circuits in a first sub-pixel P1 and a third sub-pixel P3, and a first power supply line 51 of a second pixel column may simultaneously provide a first power supply signal to pixel drive circuits in a second sub-pixel P2 and a fourth sub-pixel P4, therefore a first power supply line 51 in one repetition unit has a one-for-two structure. In the display substrate according to the present disclosure, a first power supply line is designed to have a one-for-two structure, which saves a quantity of signal lines, reduces occupied space, has a simple structure and a reasonable layout, makes full use of layout space, improves a space utilization rate, and is beneficial to improving a resolution.

In an exemplary implementation mode, two first power supply lines 51 in one repetition unit are symmetrically disposed with respect to a compensation signal line 53, and a second transistor T2 of the first pixel column and a second transistor T2 of the second pixel column are symmetrically disposed with respect to the compensation signal line 53. This symmetrical structure according to the present disclosure may ensure that a drops of voltages written by the first power supply lines into the second transistor T2 are substantially the same, ensuring display uniformity.

In an exemplary implementation mode, the ninth connection electrode 19 may be in a shape of block (for example, a rectangle), and may be disposed between third gate electrodes 33 of two adjacent sub-pixels in the first direction X, and the ninth connection electrode 19 is simultaneously connected to the first region of the third active layer 23 and the compensation signal line 53 through the fourth via V4, thereby achieving that a compensation signal is written into a first electrode of a third transistor T3 by the compensation signal line 53.

In an exemplary implementation mode, since the first regions of the third active layers in the first sub-pixel P1 and the second sub-pixel P2 are connected to each other, and the first sub-pixel P1 and the second sub-pixel P2 share one fourth via V4, the first sub-pixel P1 and the second sub-pixel P2 share one ninth connection electrode 19. Since the first regions of the third active layers in the third sub-pixel P3 and the fourth sub-pixel P4 are connected to each other, and the third sub-pixel P3 and the fourth sub-pixel P4 share one fourth via V4, the third sub-pixel P3 and the fourth sub-pixel P4 share one ninth connection electrode 19.

In an exemplary implementation mode, the compensation signal line 53 may simultaneously provide a compensation signal to pixel drive circuits in four sub-pixels so that four pixel drive circuits in one repetition unit may share one compensation signal line 53, i.e., the compensation signal line 53 in one repetition unit has a one-for-four structure. In the display substrate according to the present disclosure, a compensation signal line is designed to have the one-for-four structure, which saves a quantity of signal lines, reduces occupied space, has a simple structure and a reasonable layout, makes full use of layout space, improves a space utilization rate, and is beneficial to improving a resolution.

In an exemplary implementation mode, the compensation signal line 53 is disposed between the first pixel column and the second pixel column, and a third transistor T3 of the first pixel column and a third transistor T3 of the second pixel column are symmetrically disposed with respect to the compensation signal line 53. This symmetrical structure according to the present disclosure may ensure that Resistor-Capacitor (RC) delays of compensation signals written into the third transistors T3 are substantially the same, ensuring display uniformity.

In an exemplary implementation mode, positions of respective patterns in the third conductive layer in the first sub-pixel P1 and position of respective patterns in the third conductive layer in the third sub-pixel P3 may be substantially mirror-symmetric with respect to a horizontal reference line. Positions of respective patterns in the third conductive layer in the second sub-pixel P2 and positions of respective patterns in the third conductive layer in the fourth sub-pixel P4 may be substantially mirror-symmetric with respect to the horizontal reference line. The positions of the respective patterns in the third conductive layer in the first sub-pixel P1 and the positions of the respective patterns in the third conductive layer in the second sub-pixel P2 may be substantially mirror-symmetric with respect to a vertical reference line. The positions of the respective patterns in the third conductive layer in the third sub-pixel P3 and the positions of the respective patterns in the third conductive layer in the fourth sub-pixel P4 may be substantially mirror-symmetric with respect to the vertical reference line.

In an exemplary implementation mode, in a process of forming the pattern of the third conductive layer, a wet etching process is first adopted to form the pattern of the third conductive layer, so that at least one connection electrode is simultaneously connected to the second conductive layer and the semiconductor layer through a via of a transfer structure. The via of the transfer structure may at least include two half holes: a shallow half hole and a deep half hole. The second insulating layer in the shallow half hole is removed to expose a surface of the semiconductor layer, the second insulating layer and the first insulating layer in the deep half hole are removed to expose a surface of the second conductive layer, thereby achieving that the connection electrode is simultaneously connected to the semiconductor layer and the second conductive layer by the shallow half hole and the deep half hole. In an exemplary implementation mode, a distance is provided between an end of the connection electrode and an edge of the shallow half hole in a region of the shallow half hole, i.e., the connection electrode does not fully cover the shallow half hole.

In an exemplary implementation mode, after forming the pattern of the third conductive layer by the wet etching process, the second insulating layer in a region other than the third conductive layer is etched by a dry etching process in a self-alignment process using the third conductive layer as a mask, and a second conductorization is performed on the exposed semiconductor layer while the second insulating layer is etched away, forming a second conductorized region.

In an exemplary implementation mode, during a second conductorization process, an edge portion of the semiconductor layer covered by the third conductive layer is also conductorized, i.e., the semiconductor layer after the second conductorization extends to the first conductorized region, and a twice conductorized region is formed in an overlapping region between the first conductorized region and the second conductorized region, so that a reliable connection between the third conductive layer and the semiconductor layer may be ensured.

(6) Forming patterns of a third insulating layer and a planarization layer. In an exemplary implementation mode, forming the patterns of the third insulating layer and the planarization layer may include first depositing a third insulating thin film on the base substrate on which the aforementioned patterns are formed, then coating a planarization thin film, and patterning the planarization thin film and the third insulating thin film by a patterning process to form the third insulating layer that covers the third conductive layer and the pattern of the planarization layer provided on the third insulating layer, and the planarization layer is provided with a plurality of vias, as shown in FIG. 10.

In an exemplary implementation mode, vias of each sub-pixel at least include an eleventh via V11.

In an exemplary implementation mode, an orthographic projection of the eleventh via V11 on the base substrate is within a range of an orthographic projection of the fifth connection electrode 15 on the base substrate. The third insulating layer and the planarization layer in the eleventh via V11 are etched away to expose a surface of the fifth connection electrode 15, and the eleventh via V11 is configured such that a tenth connection electrode to be formed subsequently is connected to the fifth connection electrode 15 through the eleventh via V11.

In an exemplary implementation mode, this process adopts a one-time patterning process to simultaneously form vias on the third insulating layer and the planarization layer, i.e., a MASK plate (MASK) process in which the third insulating layer and the planarization layer share one-time halftone or gray tone, and times of patterning processes is effectively reduced.

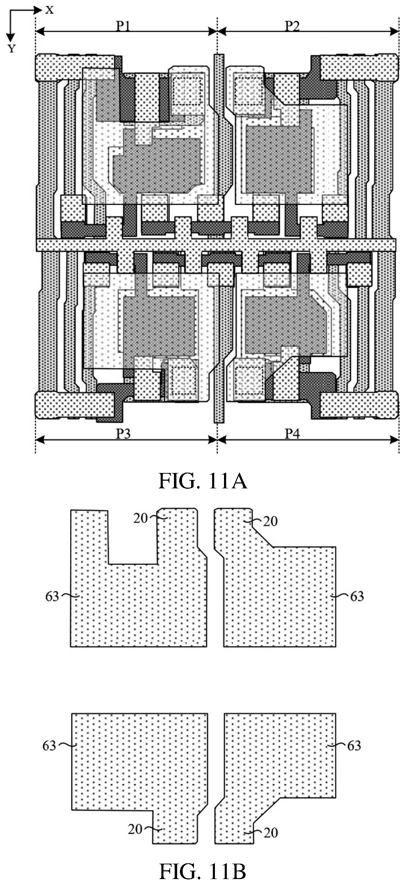

(7) Forming a pattern of a fourth conductive layer. In an exemplary implementation mode, forming the pattern of the fourth conductive layer may include: depositing a fourth conductive thin film on the base substrate on which the aforementioned patterns are formed, patterning the fourth conductive thin film through a patterning process to form the pattern of the fourth conductive layer on a color film layer, as shown in FIG. 11A and FIG. 11B, wherein FIG. 11B is a schematic diagram of the fourth conductive layer in FIG. 11A.

In an exemplary implementation mode, the fourth conductive layer of each sub-pixel in the display substrate may at least include a tenth connection electrode 20 and a first electrode 63.

In an exemplary implementation mode, the first electrode 63 may be in a shape of a rectangle, corners of the rectangle may be provided with chamfers, grooves or protrusions, and an orthographic projection of the first electrode 63 on the base substrate is at least partially overlapped with the orthographic projection of the second plate 62 on the base substrate.

In an exemplary implementation mode, the tenth connection electrode 20 may be in a shape of a block (for example, a rectangle), may be on a side of the first electrode 63 away from the scan signal line 30, a first end of the tenth connection electrode 20 is connected to the first electrode 63, a second end of the tenth connection electrode 20 extends in a direction away from the scan signal line 30, and is connected to the fifth connection electrode 15 through the eleventh via V11.

In an exemplary implementation mode, in at least one sub-pixel, the tenth connection electrode 20 and the first electrode 63 may be of an interconnected integral structure.

In an exemplary implementation mode, four first electrodes 63 in one repetition unit are arranged in a square, the upper left first electrode is connected to the pixel drive circuit in the first sub-pixel P1, the upper right first electrode is connected to the pixel drive circuit in the second sub-pixel P2, the lower left first electrode is connected to the pixel drive circuit in the third sub-pixel P3, and the lower right first electrode is connected to the pixel drive circuit in the fourth sub-pixel P4. In some possible implementation modes, the first electrode may serve as an anode of the light emitting device, and an arrangement of the first electrodes may be adjusted according to actual needs, which is not limited here in the present disclosure.

In an exemplary implementation mode, the first conductive layer may be made of a transparent conductive material, such as Indium Tin Oxide (ITO) or Indium Zinc Oxide (IZO).

In an exemplary implementation mode, the first electrode 63 may also serve as an auxiliary capacitor for the storage capacitor. Since the first electrode 63 is connected to the tenth connection electrode 20, the tenth connection electrode 20 is connected to the first electrode 61 through the fifth connection electrode 15, the third connection electrode 13, and the first connection electrode 11, the first electrode 63 has a potential of the second node in the pixel drive circuit, so that the first electrode 63 with the potential of the second node and the second plate 62 with the potential of the first node form the auxiliary capacitor, and the auxiliary capacitor and the storage capacitor are connected in parallel. The present disclosure utilizes the first electrode to form the auxiliary capacitor, and the auxiliary capacitor and the storage capacitor are connected in parallel, so that on one hand, a capacitance value of the storage capacitor can be effectively increased, on the other hand, a plate area can be reduced under a condition of ensuring the capacitance value of the storage capacitor, and an occupied area can be effectively reduced.

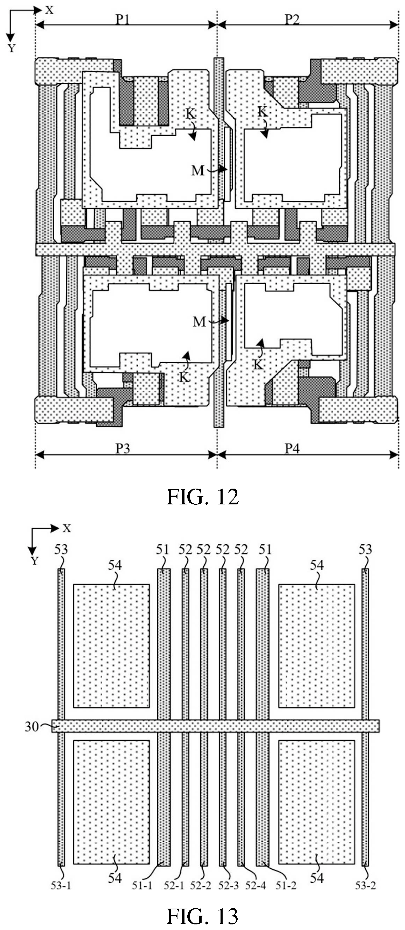

(8) Forming a pixel definition layer. In an exemplary implementation mode, forming the pattern of the pixel definition layer may include coating a pixel definition thin film on the base substrate on which the aforementioned patterns are formed, and patterning the pixel definition thin film by a patterning process to form the pixel definition layer that covers the fourth conductive layer, as shown in FIG. 12.

In an exemplary implementation mode, a pixel opening K is formed on the pixel definition layer of each sub-pixel in the display substrate, the pixel definition thin film in the pixel opening K is removed to expose a part of a surface of the first electrode 63, and an orthographic projection of the pixel opening K on the base substrate is within a range of an orthographic projection of the first electrode 63 on the base substrate.

In an exemplary implementation mode, a shape of the pixel opening K may be similar to a shape of the first electrode 63 on a plane parallel to the base substrate, and a shape of a cross-section of the pixel opening K may be rectangular, trapezoidal or the like on a plane perpendicular to the base substrate.

In an exemplary implementation mode, a shape of a pixel opening may include any one or more of following: a triangle, a rectangle, a trapezoid, a parallelogram, a pentagon, a hexagon, a circle, and an ellipse.

In an exemplary implementation mode, shapes of pixel openings of four sub-pixels may be the same or may be different. Areas of the pixel openings of the four sub-pixels may be the same or may be different.

In an exemplary implementation mode, shapes and areas of pixel openings of four sub-pixels may be different to accommodate transmittances of filters of different sub-pixels, so that light emitting devices of the four sub-pixels may emit light with same brightness under different currents, service lives of light emitting devices of the four sub-pixels are optimized to a maximum extent, and a product life is ensured.

In an exemplary implementation mode, at least one partition groove M may also be provided on the pixel definition layer of each repetition unit in the display substrate, and the at least one partition groove M may be in a shape of a strip with a main body portion extending along the second direction Y, and may be provided between adjacent pixel openings K in the first direction X. For example, a partition groove M may be provided between a pixel opening K of the first sub-pixel P1 and a pixel opening K of the second sub-pixel P2. For another example, the partition groove M may be provided between a pixel opening K of the third sub-pixel P3 and a pixel opening K of the fourth sub-pixel P4. In an exemplary implementation mode, the partition groove M is configured to cut off an organic emitting layer to be formed subsequently, block a lateral propagation path of hole-type carriers, eliminate a lateral leakage, and eliminate a lateral crosstalk of the sub-pixels.

In an exemplary implementation mode, the pixel definition layer may be made of polyimide, acrylic, or polyethylene terephthalate, etc.

(9) Forming patterns of an organic emitting layer and a cathode. In an exemplary implementation mode, forming the patterns of the organic emitting layer and the cathode may include: forming a pattern of an organic emitting layer, wherein the organic emitting layer is connected to the first electrode 63 through the pixel opening K. Subsequently, a second electrode is formed, and the second electrode is connected to the organic emitting layer. In an exemplary implementation mode, the second electrode may serve as a cathode of a light emitting device.

In an exemplary implementation mode, the organic emitting layer may include an Emitting Layer (EML) and any one or more of a Hole Injection Layer (HIL), a Hole Transport Layer (HTL), an Electron Block Layer (EBL), a Hole Block Layer (HBL), an Electron Transport Layer (ETL), and an Electron Injection Layer (EIL). In an exemplary implementation mode, the organic emitting layer may be formed through evaporation using a Fine Metal Mask (FMM) or an Open Mask, or through an inkjet process.

(10) Forming a pattern of an encapsulation structure layer. In an exemplary implementation mode, forming the pattern of the encapsulation structure layer may include: depositing a first inorganic thin film using an open mask, so as to form a first encapsulation layer. Then, inkjet printing of an organic material is performed on the first encapsulation layer by using an inkjet printing process, and a second encapsulation layer is formed after curing. then, depositing a second inorganic thin film by using an open mask to form a third encapsulation layer, wherein the first encapsulation layer, the second encapsulation layer and the third encapsulation layer form the encapsulation structure layer. The first encapsulation layer and the third encapsulation layer may be made of any one or more of Silicon Oxide (SiOx), Silicon Nitride (SiNx), Silicon Carbide (SiC), Silicon Carbonitride (SiCN), and Silicon Oxynitride (SiON), and may be a single layer, a multi-layer, or a composite layer. The second encapsulation layer may be made of a resin material, thereby forming a stacked structure of inorganic material/organic material/inorganic material, wherein an organic material layer is disposed between two inorganic material layers, thus ensuring that external moisture cannot enter a light-emitting structure layer.

So far, manufacturing of the display substrate according to the exemplary embodiment of the present disclosure is completed. The display substrate may include a drive circuit layer provided on the base substrate, a light emitting structure layer provided on a side of the drive circuit layer away from the base substrate, and the encapsulation structure layer provided on a side of the light emitting structure layer away from the base substrate. In a direction perpendicular to the base substrate, the drive circuit layer may include a first conductive layer, a second conductive layer, a first insulating layer, a semiconductor layer, a second insulating layer, a third conductive layer, a third insulating layer and a planarization layer provided sequentially on the base substrate, the light emitting structure layer may include a first electrode, a pixel definition layer, an organic emitting layer and a second electrode, and the encapsulation structure layer may include a first encapsulation layer, a second encapsulation layer and a third encapsulation layer that are stacked.

In an exemplary implementation mode, for a display substrate including a color filter structure layer, after the third conductive layer is formed, the third insulating layer may be formed first, then a red color filter layer, a green color filter layer, and a blue color filter layer may be sequentially formed, and then a planarization layer may be formed, which is not limited here in the present disclosure.

In an exemplary implementation mode, the base substrate may be a flexible substrate, or a rigid substrate. The rigid substrate may be made of, but is not limited to, one or more of glass and quartz. The flexible base substrate may be made of, but is not limited to, one or more of polyethylene terephthalate, ethylene terephthalate, polyether ether ketone, polystyrene, polycarbonate, polyarylate, polyarylester, polyimide, polyvinyl chloride, polyethylene, and textile fiber. In an exemplary implementation mode, the flexible substrate may include a first flexible material layer, a first inorganic material layer, a semiconductor layer, a second flexible material layer, and a second inorganic material layer which are stacked, wherein materials of the first flexible material layer and the second flexible material layer may be Polyimide (PI), Polyethylene Terephthalate (PET), or a surface-treated polymer soft film, or the like, materials of the first inorganic material layer and the second inorganic material layer may be Silicon Nitride (SiNx) or Silicon Oxide (SiOx), or the like, for improving a water and oxygen resistance capability of the base substrate, and a material of the semiconductor layer may be amorphous silicon (a-si).

In an exemplary implementation mode, the second conductive layer and the third conductive layer may be made of a metal material, such as any one or more of Argentum (Ag), Copper (Cu), Aluminum (Al), and Molybdenum (Mo), or an alloy material of the above metals, such as an Aluminum Neodymium alloy (AlNd) or a Molybdenum Niobium alloy (MoNb), and may be of a single-layer structure or a multi-layer composite structure, such as Mo/Cu/Mo. The first insulating layer, the second insulating layer, and the second insulating layer may be made of any one or more of Silicon Oxide (SiOx), Silicon Nitride (SiNx), and Silicon Oxynitride (SiON), and may be a single layer, a multi-layer, or a composite layer. The planarization layer may be made of an organic material such as resin.

At present, existing display substrates have problems such as signal interference. Through research, the inventors of the present application have found that there is a case of a cross-line connection since four data signal lines in one repetition unit are respectively provided on two sides of the repetition unit in the first direction X, and thus a data signal line causes signal interference to a second electrode of a first transistor and a storage capacitor. Taking a first data signal line and a second data signal line as an example, the first data signal line is connected to a first electrode of a first transistor T1 in a first sub-pixel P1, and the second data signal line is connected to a first electrode of a first transistor T1 in a third sub-pixel P3. Since the second data signal line is located on a side of the first data signal line in the first direction X and the first transistor T1 is located on a side of the second data signal line in the first direction X, the first electrode of the first transistor T1 in the first sub-pixel P1 needs to be connected to the first data signal line across the second data signal line. In the present application, by setting a position of a storage capacitor so that the storage capacitor is close to a compensation signal line and remote from a data signal line, a first transistor T1 is remote from the data signal line due to a fact that a second plate of the storage capacitor and a second electrode of the first transistor T1 are of an interconnected integral structure, so that the first transistor T1 is remote from the data signal line, and thus an influence of data voltage jump on the data signal line on the second electrode of the first transistor T1 and the storage capacitor may be reduced, the data voltage jump can be avoided from affecting normal operation of a pixel drive circuit, and display effects and a display quality can be improved.

At present, existing display substrates have problems of complex production processes and high production costs, etc. For example, a preparation process of a drive structure layer in a display substrate requires nine times of patterning (MASK) processes, which not only has a relatively low production efficiency and a relatively high production cost, but also affects a product yield adversely. An embodiment of the present disclosure provides a display substrate with a bottom emission structure, a first power supply line, a data signal line, and a compensation signal line are arranged on a SHIELD layer and located on a side of a semiconductor layer close to a base substrate, and structures such as a scan signal line and gate electrodes of a plurality of transistors are arranged on a GT layer and located on a side of the semiconductor layer away from the base substrate, which not only reduces one conductive layer, but also reduces a patterning process of transfer vias and a patterning process of a transfer conductive layer, so that a preparation process of the drive structure layer requires only six patterning processes, thereby reducing times of patterning processes, effectively improving a production efficiency, effectively reducing a production cost, and maximizing a product yield rate.

According to a display substrate of an embodiment of the present disclosure, a 3T1C pixel drive circuit using one scan signal line is adopted, in which the scan signal line is connected to a first transistor and a third transistor in a pixel drive circuit. By reducing a quantity of scan signal lines, a structure of the pixel drive circuit can be simplified, an area occupied by the pixel drive circuit can be reduced, which is beneficial to achieving high-resolution display. In addition, since one repetition unit only needs to be driven by one scan signal line, a quantity of corresponding gate drive circuits (GOA) and clock signal lines (CLK) may be reduced by a plurality of times, areas occupied by the gate drive circuits and clock signal lines are effectively reduced, which is beneficial to achieving a narrow bezel, and improving product advantages.

In the display substrate according to the exemplary embodiment of the present disclosure, a transparent storage capacitor is composed of a transparent conductive layer and a transparent semiconductor layer, so that light may be emitted through the transparent storage capacitor, thus the storage capacitor may be disposed in a pixel opening, and not only a capacitance amount of the storage capacitor may be effectively increased, but also a pixel aperture ratio may be effectively increased.

The pixels according to an embodiment of the present disclosure adopt a square arrangement of sub-pixels and adopt a structure of first power supply lines with a non-mesh structure, the pixel aperture ratio is effectively increased, and a display effect is improved, which is more suitable for displaying of displays.

The manufacturing process in the present disclosure may be compatible well with an existing manufacturing process, is simple in process implementation, is easy to implement, and has a high production efficiency, a low production cost, and a high yield.

A structure shown in the present disclosure and a manufacturing process thereof are merely exemplary description. In an exemplary implementation, a corresponding structure may be changed and patterning processes may be added or reduced according to actual needs, which is not limited here in the present disclosure.

FIG. 13 is a schematic diagram of a structure of a drive circuit layer in another display substrate according to an exemplary embodiment of the present disclosure, illustrating a structure of an arrangement of signal lines in one repetition unit (four sub-pixels) of a bottom emission display substrate. In an exemplary implementation mode, at least one repetition unit may include a first sub-pixel P1, a second sub-pixel P2, a third sub-pixel P3, and a fourth sub-pixel P4 arranged in a square, and each sub-pixel includes a pixel drive circuit 54.

In an exemplary implementation mode, at least one repetition unit may include one scan signal line 30, two first power supply lines 51, two compensation signal lines 53, and fourth data signal lines 52, and the above-mentioned signal lines are connected to pixel drive circuits in corresponding sub-pixels 54 respectively.

In an exemplary implementation mode, the scan signal line 30 may be in a shape of a line with a main body portion extending along the first direction X, and the first power supply lines 51, the data signal lines 52, and the compensation signal lines 53 may each be in a shape of a line with a main body portion extending along the second direction Y. In an exemplary implementation mode, the scan signal line 30 may be provided in a middle region of the repetition unit in the second direction Y, the two first power supply lines 51 and the four data signal lines 52 may be located in a middle region of the repetition unit in the first direction X, and the two compensation signal lines 53 may be located on two sides of the repetition unit in the first direction X. One first power supply line 51 of the two first power supply lines 51 may be located between one compensation signal line 53 and a data signal line 52, and the other first power supply line 51 of the two first power supply lines 51 may be located between the other compensation signal line 53 and a data signal line 52.

In an exemplary implementation mode, a pixel drive circuit of at least one sub-pixel may include a first transistor, a second transistor, a third transistor, and a storage capacitor, and a related connection structure is basically the same as that of the foregoing embodiment, which will not be repeated herein.

In an exemplary implementation mode, the storage capacitor may at least include a first plate and a second plate as capacitor plates. In the at least one sub-pixel, the first plate and the second plate may be provided between a first power supply line 51 and a compensation signal line 53.

In an exemplary implementation mode, in at least one repetition unit, the two compensation signal lines 53 may include a first compensation signal line 53-1 and a second compensation signal line 53-2 sequentially disposed along the first direction X. The first compensation signal line 53-1 may be disposed on a side of the repetition unit in a direction opposite to first direction X, and the second compensation signal line 53-2 may be disposed on a side of the repetition unit in first direction X. The two first power supply lines 51 may include a first first power supply line 51-1 and a second first power supply line 51-2 sequentially disposed along the first direction X. The four data signal lines 52 may include a first data signal line 52-1, a second data signal line 52-2, a third data signal line 52-3, and a fourth data signal line 52-4 sequentially disposed along the first direction X, and the four data signal lines 52 may be disposed between the first first power supply line 51-1 and the second first power supply line 51-2.

In the present disclosure, by arranging a storage capacitor between a first power supply line and a compensation signal line, and arranging the four data signal lines between the two first power supply lines, a first power supply line with a constant voltage can effectively shield an influence of data voltage jump on a data signal line on a second electrode of the first transistor T1 and the storage capacitor, which prevents the data voltage jump from affecting normal operation of a pixel drive circuit, and improve display effects.

In an exemplary implementation mode, the display substrate according to the present disclosure may be applied to a display device with a pixel drive circuit, such as an OLED, quantum dot display (QLED), light emitting diode display (Micro LED or Mini LED), or Quantum Dot Light Emitting Diode display (QDLED), which is not limited here in the present disclosure.

An exemplary embodiment of the present disclosure further provides a method for manufacturing a display substrate for manufacturing the aforementioned display substrate. In an exemplary implementation mode, the display substrate includes a plurality of repetition units, at least one repetition unit includes a plurality of sub-pixels forming at least two pixel rows and at least two pixel columns. The method may include:
forming a pixel drive circuit in at least one sub-pixel, wherein the pixel drive circuit is connected to a data signal line and a compensation signal line extending along a pixel column direction respectively, the data signal line is configured to provide a data signal to the pixel drive circuit, the compensation signal line is configured to provide a compensation signal to the pixel drive circuit; the pixel drive circuit at least includes a storage capacitor, the storage capacitor at least includes two capacitor plates that are stacked, the two capacitor plates are disposed between the data signal line and the compensation signal line; a first distance is provided between an edge of at least one capacitor plate in the at least one sub-pixel close to the compensation signal line and an edge of the compensation signal line close to the capacitor plate, a second distance is provided between an edge of the capacitor plate close to the data signal line and an edge of the data signal line close to the capacitor plate, the first distance is less than the second distance, and the first distance and the second distance are dimensions in a pixel row direction.

The present disclosure further provides a display device which includes the display substrate according to the aforementioned embodiments. The display device may be any product or component with a display function, such as a mobile phone, a tablet computer, a television, a display, a laptop computer, a digital photo frame, and a navigator.

Although implementation modes disclosed in the present disclosure are as above, it should be noted that the above implementation modes are exemplary only rather than restrictive. Therefore, the present disclosure is not limited to what is specifically shown and described here. Various modifications, substitutions, or omissions may be made in forms and details of implementation modes without departing from the scope of the present disclosure.

## Claims

1. A display substrate, comprising a plurality of repetition units, wherein at least one repetition unit comprises a plurality of sub-pixels forming at least two pixel rows and at least two pixel columns, at least one sub-pixel comprises a pixel drive circuit, the pixel drive circuit is respectively connected to a data signal line and a compensation signal line extending along a pixel column direction, the data signal line is configured to provide a data signal to the pixel drive circuit, the compensation signal line is configured to provide a compensation signal to the pixel drive circuit; the pixel drive circuit at least comprises a storage capacitor, the storage capacitor at least comprises two capacitor plates that are stacked, the two capacitor plates are disposed between the data signal line and the compensation signal line; a first distance is provided between an edge of at least one capacitor plate in the at least one sub-pixel close to the compensation signal line and an edge of the compensation signal line close to the capacitor plate, a second distance is provided between an edge of the at least one capacitor plate close to the data signal line and an edge of the data signal line close to the capacitor plate, the first distance is less than the second distance, and the first distance and the second distance are dimensions in a pixel row direction.

2. The display substrate according to claim 1, wherein a ratio of the first distance to the second distance is 0.35 to 0.75.

3. The display substrate according to claim 1, wherein a ratio of the first distance to the second distance is 0.6 to 0.7.

4. The display substrate according to claim 3, wherein the first distance ranges from 5.5 µm to 6.5 µm and the second distance ranges from 8.5 µm to 9.5 µm.

5. The display substrate according to claim 1, wherein a ratio of the first distance to the second distance is 0.4 to 0.5.

6. The display substrate according to claim 5, wherein the first distance ranges from 5.5 µm to 6.5 µm and the second distance ranges from 12.5 µm to 13.5 µm.

7. The display substrate according to claim 1, wherein a ratio of the first distance to the second distance is 0.65 to 0.75.

8. The display substrate according to claim 7, wherein the first distance ranges from 8.5 µm to 9.5 µm and the second distance ranges from 12.5 µm to 13.5 µm.

9. The display substrate according to any one of claims 1 to 8, wherein the two capacitor plates comprise a first plate and a second plate, and the pixel drive circuit further comprises a first transistor, a second transistor, and a third transistor, a first electrode of the first transistor is connected to the data signal line, a second electrode of the first transistor is connected to the first plate and a gate electrode of the second transistor respectively, a first electrode of the third transistor is connected to the compensation signal line, and a second electrode of the third transistor is connected to the second plate and a second electrode of the second transistor respectively, a first distance is provided between an edge of the second plate close to the compensation signal line and an edge of the compensation signal line close to the second plate, and a second distance is provided between an edge of the second plate close to the data signal line and an edge of the data signal line close to the second plate.

10. The display substrate according to claim 9, wherein the first transistor at least comprises a first active layer, and the first active layer and the second plate are of an interconnected integral structure.

11. The display substrate according to any one of claims 1 to 8, wherein the pixel drive circuit is further connected to a first power supply line extending along the pixel column direction; the at least one repetition unit comprises one compensation signal line, two first power supply lines, and four data signal lines, the one compensation signal line is located in middle of the at least one repetition unit in the pixel row direction, the two first power supply lines are located on two sides of the repetition unit in the pixel row direction, two data signal lines of the four data signal lines are located on a side of one of the first power supply lines close to the compensation signal line, and the other two data signal lines of the four data signal lines are located on a side of the other of the first power supply lines close to the compensation signal line.

12. The display substrate according to claim 11, wherein the two first power supply lines comprise a first first power supply line and a second first power supply line sequentially disposed along the pixel row direction, and the four data signal lines comprise a first data signal line, a second data signal line, a third data signal line, and a fourth data signal line sequentially disposed along the pixel row direction; the first data signal line is located on a side of the first first power supply line close to the compensation signal line, the second data signal line is located on a side of the first data signal line close to the compensation signal line, the two capacitor plates are disposed between the second data signal line and the compensation signal line, a first distance is provided between an edge of a capacitor plate close to the compensation signal line and an edge of the compensation signal line close to the capacitor plate, a second distance is provided between an edge of the capacitor plate close to the second data signal line and an edge of the second data signal line close to the capacitor plate; the fourth data signal line is located on a side of the second first power supply line close to the compensation signal line, the third data signal line is located on a side of the fourth data signal line close to the compensation signal line, the two capacitor plates are disposed between the third data signal line and the compensation signal line, a first distance is provided between an edge of a capacitor plate close to the compensation signal line and an edge of the compensation signal line close to the capacitor plate, a second distance is provided between an edge of the capacitor plate close to the third data signal line and an edge of the third data signal line close to the capacitor plate.

13. The display substrate according to any one of claims 1 to 8, wherein the pixel drive circuit is further connected to a first power supply line extending along the pixel column direction; the at least one repetition unit comprises two compensation signal lines, two first power supply lines, and four data signal lines, the four data signal lines are located in middle of the at least one repetition unit in the pixel row direction, the two compensation signal lines are located on two sides of the at least one repetition unit in the pixel row direction, and the two first power supply lines are respectively located on a side of the four data signal lines close to a compensation signal line.

14. The display substrate according to claim 13, wherein the two compensation signal lines comprise a first compensation signal line and a second compensation signal line sequentially disposed along the pixel row direction, the two first power supply lines comprise a first first power supply line and a second first power supply line sequentially disposed along the pixel row direction, and the four data signal lines comprise a first data signal line, a second data signal line, a third data signal line, and a fourth data signal line sequentially disposed along the pixel row direction; the first first power supply line is located on a side of the first data signal line close to the first compensation signal line, and the two capacitor plates are disposed between the first compensation signal line and the first first power supply line; the second first power supply line is located on a side of the fourth data signal line close to the second compensation signal line, and the two capacitor plates are disposed between the second compensation signal line and the second first power supply line.

15. A display device, comprising the display substrate according to any one of claims 1 to 14.

16. A method for manufacturing a display substrate, wherein the display substrate comprises a plurality of repetition units, at least one of the repetition units comprises a plurality of sub-pixels forming at least two pixel rows and at least two pixel columns; the method comprises:
forming a pixel drive circuit in at least one sub-pixel, wherein the pixel drive circuit is connected to a data signal line and a compensation signal line extending along a pixel column direction respectively, the data signal line is configured to provide a data signal to the pixel drive circuit, the compensation signal line is configured to provide a compensation signal to the pixel drive circuit; the pixel drive circuit at least comprises a storage capacitor, the storage capacitor at least comprises two capacitor plates that are stacked, the two capacitor plates are disposed between the data signal line and the compensation signal line; a first distance is provided between an edge of at least one capacitor plate in the at least one sub-pixel close to the compensation signal line and an edge of the compensation signal line close to the capacitor plate, a second distance is provided between an edge of the at least one capacitor plate close to the data signal line and an edge of the data signal line close to the capacitor plate, the first distance is less than the second distance, and the first distance and the second distance are dimensions in a pixel row direction.
